(19) Europäisches Patentamt
European Patent Office
Office européen des brevets

(11) EP 2 975 649 A1

(12) # EUROPEAN PATENT APPLICATION
published in accordance with Art. 153(4) EPC

(43) Date of publication:
**20.01.2016 Bulletin 2016/03**

(21) Application number: **14764651.7**

(22) Date of filing: **11.03.2014**

(51) Int Cl.:
***H01L 29/786*** *(2006.01)* ***C08G 79/00*** *(2006.01)*
***H01L 21/316*** *(2006.01)* ***H01L 21/336*** *(2006.01)*
***H01L 51/05*** *(2006.01)* ***H01L 51/30*** *(2006.01)*
***H01L 51/40*** *(2006.01)*

(86) International application number:
**PCT/JP2014/056280**

(87) International publication number:
**WO 2014/142105 (18.09.2014 Gazette 2014/38)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **14.03.2013 JP 2013051218**

(71) Applicant: **Toray Industries, Inc.**
**Tokyo 103-8666 (JP)**

(72) Inventors:
- **MURASE, Seiichiro**
**Otsu-shi**
**Shiga 520-8558 (JP)**
- **YAMAMOTO, Maiko**
**Otsu-shi**
**Shiga 520-8558 (JP)**
- **MATA, Junji**
**Otsu-shi**
**Shiga 520-8558 (JP)**
- **SHIMIZU, Hiroji**
**Otsu-shi**
**Shiga 520-8558 (JP)**

(74) Representative: **Hoefer & Partner Patentanwälte mbB**
**Pilgersheimer Straße 20**
**81543 München (DE)**

(54) **FIELD EFFECT TRANSISTOR**

(57) There is provided a field effect transistor which comprises a gate insulating layer, a gate electrode, a semiconductor layer, a source electrode and a drain electrode. The gate insulating layer contains an organic compound that contains a silicon-carbon bond and a metal compound that contains a bond between a metal atom and an oxygen atom; and the metal atoms are contained in the gate insulating layer in an amount of 10 to 180 parts by weight with respect to 100 parts by weight of the total of carbon atoms and silicon atoms. This field effect transistor (FET) has high mobility and a low voltage of the threshold value, while being suppressed in leak current.

[Figure 1]

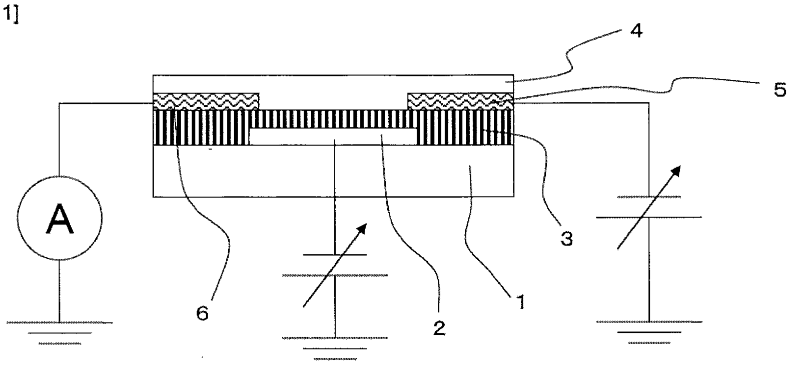


EP 2 975 649 A1

## Description

[Technical Field]

The present invention relates to a field effect transistor, a composition and a method for manufacturing a field effect transistor using the composition. More particularly, the present invention relates to a composition capable of being applied to an insulating layer in a semiconductor device or a field effect transistor.

[Background Art]

A field effect transistor (hereinafter, referred to as an FET) which can be formed by a low-temperature and atmospheric process has been recently actively developed since weight of a display can be reduced and a flexible display can be realized by using a flexible substrate such as a resin. Particularly, it is desired that an FET can be formed by a low-cost and simple printing process, and materials such as organic semiconductors and carbon nanotubes which are easily formed into ink are actively investigated.

In order to form an FET by such a low-cost and simple printing process, it is preferred that not only a semiconductor material but also all constituents such as an gate insulating material can be formed by an application process such as printing.

Examples of the gate insulating materials of application type which are soluble in an organic solvent include polymers such as polyvinylphenol (for example, see Non-patent Document 1) and polyimide (for example, see Patent Document 1). However, the FET, in which a polymer is used in the gate insulating film, has excellent flexibility, but it does not have sufficient FET characteristics such as mobility and a voltage of the threshold value.

As an insulating composition prepared by adding additive components to the polymer, an example of a composition prepared by adding a metal alkoxide compound or a metal chelate compound to polysiloxane is disclosed (e.g., Patent Documents 2 and 3). By adding these metal compounds, polymerization of polysiloxane or curing of the insulating film is accelerated. Further, a method of adding, to a polymer, an organic metal compound such as a titanium compound, a zirconium compound, a hafnium compound or an aluminum compound, respectively having a high dielectric constant, in order to improve the FET characteristics by utilizing an insulating film having a high dielectric constant, is known (e.g. , Patent Documents 4 and 5). In addition to this, an application type gate insulating material, which has a high dielectric constant and an insulating property by adding metal atoms and an organic molecule to a polymer, is known (e.g., Patent Document 6).

[Citation List]

[Patent Literature]

[PTL 1] Japanese Patent Laid-open Publication No. 2009-4394
[PTL 2] WO 2009/116373 A
[PTL 3] Japanese Patent Laid-open Publication No. 2002-311591
[PTL 4] Japanese Patent Laid-open Publication No. 2007-154164
[PTL 5] Japanese Patent Laid-open Publication No. 2012-111864
[PTL 6] Japanese Patent Laid-open Publication No. 2010-267657


[Non Patent Literature]

[NPL 1] "APPLIED PHYSICS LETTERS, vol. 82, p.4175-4177 (2003)

[Summary of Invention]

[Technical Problem]

However, a material to which a low-cost and simple application process can be applied and which enables the FET to exert sufficient FET characteristics has not been attained.

In view of the above-mentioned problem, it is an object of the present invention to provide an FET which has high mobility and a low voltage of the threshold value while being suppressed in leak current, and a material for preparing the FET.

[Solution to Problem]

In order to solve the above-mentioned problem, the present invention has the following constitution. That is, a field effect transistor comprising a gate insulating layer, a gate electrode, a semiconductor layer, a source electrode and a drain electrode, wherein the gate insulating layer contains an organic compound containing a silicon-carbon bond and a metal compound containing a bond between a metal atom and an oxygen atom; and the metal atoms are contained in the gate insulating layer in an amount of 10 to 180 parts by weight with respect to 100 parts by weight of the total of carbon atoms and silicon atoms.

Further, the present invention pertains to a composition comprising (a) a metal chelate represented by the general formula (1), (b) a polymer having a weight average molecular weight of 1000 or more, and (c) a solvent, (b) the polymer having a weight average molecular weight of 1000 or more being contained in an amount of 5 to 90 parts by weight with respect to 100 parts by weight of (a) the metal chelate represented by the general formula (1):

$$R^1_xM(OR^2)_{y-x} \qquad (1)$$

(wherein, $R^1$ represents a monovalent bidentate ligand and in the case of a plurality of $R^1$s, $R^1$s may be the same or different, $R^2$ represents hydrogen, an alkyl group, an acyl group or an aryl group and in the case of a plurality of $R^2$s, $R^2$s may be the same or different, M represents a y-valent metal atom, a value of y is 1 to 6, and x represents an integer of 1 to y).

Moreover, the present invention pertains to a method for manufacturing a field effect transistor comprising a step of applying the composition onto a substrate and drying the composition to form a gate insulating layer.

[Advantageous Effects of Invention]

According to the present invention, it is possible to obtain an FET to which a low-cost and simple application process can be applied and which has high mobility and low voltage of the threshold value, while being suppressed in leak current.

[Brief Description of Drawings]

Fig. 1 is a schematic sectional view showing an FET which is an aspect of the present invention.
Fig. 2 is a schematic sectional view showing an FET which is another aspect of the present invention.

[Description of Embodiments]

Field Effect Transistor (FET)

The FET of the present invention is an FET having at least a gate insulating layer, a gate electrode, a semiconductor layer, a source electrode and a drain electrode. Figs. 1 and 2 are a schematic sectional view showing examples of the FET of the present invention. In Fig. 1, the source electrode 5 and the drain electrode 6 are formed on the substrate 1 having the gate electrode 2 covered with the gate insulating layer 3, and then the semiconductor layer 4 is further formed thereon. In Fig. 2, the semiconductor layer 4 is formed on the substrate 1 having the gate electrode 2 covered with the gate insulating layer 3, and then the source electrode 5 and the drain electrode 6 are further formed thereon.

Examples of a material to be used in the substrate 1 include inorganic materials such as a silicon wafer, glass, alumina sintered body and the like, and organic materials such as polyimide, polyester, polycarbonate, polysulfone, polyethersulfone, polyethylene, polyphenylenesulfide, polyparaxylene and the like.

The materials to be used for the gate electrode 2, the source electrode 5 and the drain electrode 6 may be any material as long as they are conductive materials capable of being commonly used as an electrode, and examples thereof include conductive metal oxides such as tin oxide, indium oxide and indium-tin oxide (ITO); metals such as platinum, gold, silver, copper, iron, tin, zinc, aluminum, indium, chromium, lithium, sodium, potassium, cesium, calcium, magnesium, palladium, molybdenum, amorphous silicon and polysilicon, and alloys thereof; inorganic conductive substances such as copper iodide and copper sulfide; conductive polymers, in which conductivity is improved by doping of iodine or the like, such as polythiophene, polypyrrole, polyaniline, complexes of polyethylenedioxythiophene and polystyrenesulfonic acid; and carbon materials, but the electrode material is not limited to these. These electrode materials may be used singly, or may be used as a stacked body or a mixture of plural materials.

In the FET of the present invention, the gate insulating layer 3 contains an organic compound containing a

silicon-carbon bond and a metal compound containing a bond between a metal atom and an oxygen atom. Examples of the organic compound include a silane compound represented by the general formula (3) described later, an epoxy group-containing silane compound represented by the general formula (4) described later, or condensate thereof or polysiloxane containing them as copolymerization components. Among these, more preferred one is polysiloxane. Further, the metal compound is not particularly limited as long as it contains the bond between a metal atom and an oxygen atom, and examples of thereof include metal oxides, metal hydroxides and the like. The metal atom contained in the metal compound is not particularly limited as long as it forms a metal chelate, and examples thereof include magnesium, aluminum, titanium, chromium, manganese, cobalt, nickel, copper, zinc, gallium, zirconium, ruthenium, palladium, indium, hafnium, and platinum. Among these metal atoms, aluminum is preferred from the viewpoint of ease of availability, cost, and stability of a metal chelate.

In the gate insulating layer 3, the metal atoms are contained in an amount of 10 to 180 parts by weight with respect to 100 parts by weight of the total of carbon atoms and silicon atoms. When the amount of the metal atom is within the range, it is possible to pursue a low voltage of the threshold value and a low leak current of the FET simultaneously. A more preferred range of the metal atom is 10 to 60 parts by weight with respect to 100 parts by weight of the total of carbon atoms and silicon atoms. A moreover preferred range of the metal atom is 17 to 30 parts by weight with respect to 100 parts by weight of the total of carbon atoms and silicon atoms. When the amount of the metal atom is set to this range, the effect of reducing a leak current and a voltage of the threshold value is larger.

A weight ratio of the metal atoms to 100 parts by weight of the total of carbon atoms and silicon atoms in the gate insulating layer can be determined by X-ray photoelectron spectroscopy (XPS).

A film thickness of the gate insulating layer 3 is preferably 0.05 to 5 μm, and more preferably 0.1 to 1 μm. By having a film thickness within this range, it becomes easy to form a uniform thin film and it is possible to suppress the current between source and drain which cannot be controlled by a gate voltage and achieve a high on/off ratio. The film thickness can be measured by an atomic force microscope or an ellipsometric method.

A preparation method of the gate insulating layer as described above is not particularly limited, and the gate insulating layer can be prepared, for example, by applying a method described later using a composition described later. For example, a gate insulating layer, which generally contains an organic compound having a silicon-carbon bond and a metal compound having a bond between a metal atom and an oxygen atom, the metal atoms being contained in an amount of 10 to 180 parts by weight with respect to 100 parts by weight of the total of carbon atoms and silicon atoms, is formed from a composition, described later, containing (a) a metal chelate represented by the general formula (1), (b) a polymer having a weight average molecular weight of 1000 or more, and (c) a solvent, (b) the polymer having a weight average molecular weight of 1000 or more being contained in an amount of 5 to 90 parts by weight with respect to 100 parts by weight of (a) the metal chelate represented by the general formula (1). Preferably, a gate insulating layer, which generally contains an organic compound having a silicon-carbon bond and a metal compound having a bond between a metal atom and an oxygen atom, the metal atoms being contained in an amount of 17 to 30 parts by weight with respect to 100 parts by weight of the total of carbon atoms and silicon atoms, is formed from a composition containing (b) the polymer having a weight average molecular weight of 1000 or more in an amount of 10 to 30 parts by weight with respect to 100 parts by weight of (a) the metal chelate represented by the general formula (1).

In addition, the relationship between the content ratio of atoms in the above-mentioned composition and the gate insulating layer is a rough tendency, and the above-mentioned relationship is not necessarily satisfied, depending on, for example, the kind of metal atom.

A material to be used in the semiconductor layer 4 is not particularly limited as long as it is a material exhibiting semiconductor properties, and a material having high carrier mobility is preferably used. Further, the preferred material is a material to which a low-cost and simple application process can be applied, and preferred examples thereof include organic semiconductors and carbon materials. Specific examples of the organic semiconductors include polythiophenes such as poly(3-hexylthiophene), polybenzothiophene and the like; compounds containing, in the main chain, thiophene unit such as poly(2,5-bis(2-thienyl)-3,6-dipentadecyl-thieno[3,2-b]thiop hene), poly(4,8-dihexyl-2,6-bis(3-hexylthiophene-2-yl)benzo[1,2-b: 4,5-b']dithiophene), poly(4-octyl-2-(3-octylthiophene-2-yl)thiazole), poly(5,5'-bis(4-octylthiazole-2-yl)-2,2'-bithiophene) or the like; polypyrroles; poly(p-phenylene vinylene) such as poly(p-phenylene vinylene) and the like; polyanilines; polyacetylenes; polydiacetylenes; polycarbazoles; polyfurans such as polyfuran, polybenzofuran and the like; polyheteroaryls, in which a nitrogen-containing aromatic ring is a constituent unit, such as pyridine, quinoline, phenanthroline, oxazole, oxadiazole and the like; condensed polycyclic aromatic compounds such as anthracene, pyrene, naphthacene, pentacene, hexacene, rubrene and the like; nitrogen-containing aromatic compounds such as furan, thiophene, benzothiophene, dibenzofuran, pyridine, quinoline, phenanthroline, oxazole, oxadiazole and the like; aromatic amine derivatives typified by 4,4'-bis(N-(3-methylphenyl)-N-phenylamino)biphenyl; biscarbazole derivatives such as bis(N-allylcarbazole) and bis(N-alkylcarbazole); pyrazoline derivatives; stilbene-based compounds; hydrazone-based compounds; metal phthalocyanines such as copper phthalocyanine; metal porphyrins such as copper porphyrin; distyrylbenzene derivatives; aminostyryl derivatives; aromatic acetylene derivatives; fused ring tetracarboxylic acid diimides such as naphthalene-1,4,5,8-tetracarboxylic acid diimide, perylene-3,4,9,10-tetracarboxylic acid diimide; and organic

dyes such as merocyanine, phenoxazine and rhodamine. The semiconductor layer may contain two or more kinds of these compounds.

Examples of the carbon materials include a carbon nanotube (hereinafter, referred to as a CNT), a graphene, a fullerene and the like, and the CNT is preferably used in point of the suitability for the application process and high mobility. As the CNT, any of a single-walled CNT in which one carbon film (graphene sheet) is rolled up in the shape of a cylindrical tube, a double-walled CNT in which two graphene sheets are concentrically rolled up and a multi-walled CNT in which plural graphene sheets are concentrically rolled up, may be used, and two or more thereof may be used. The single-walled CNT is preferably used from the viewpoint of exhibiting semiconductor characteristics, and among others, the single-walled CNT more preferably contains a highly semiconductor enriched single-walled CNT in an amount of 90% by weight or more. Moreover preferably, the single-walled CNT contains a highly semiconductor enriched single-walled CNT in an amount of 95% by weight or more. The content ratio of the highly semiconductor enriched single-walled CNT can be calculated from an absorption area ratio of a visible and near infrared absorption spectrum. The CNT can be obtained by a method such as an arc discharge method, a chemical vapor deposition method (CVD method) or a laser abrasion method. Moreover, a CNT having a conjugated polymer adhering to at least a part of the surface of the CNT (hereinafter, referred to as a CNT composite), is particularly preferred since the CNT composite has excellent dispersion stability in a solution and achieves high mobility.

A state in which the conjugated polymer adheres to at least a part of the surface of the CNT means a state in which a conjugated polymer covers a part of or all of the surface of the CNT surface. That n electron clouds resulting from the respective conjugated structures overlap and thereby an interaction is generated is thought to be the reason why the conjugated polymer can cover the CNT. It is possible to determine whether the CNT is covered with the conjugated polymer or not based on whether reflected color of the covered CNT changes from the color of the CNT not covered to the color of the conjugated polymer. The presence of adherents and a weight ratio of adherents to the CNT can be quantitatively identified by elemental analysis or X-ray photoelectron spectroscopy. Further, as the conjugated polymer to adhere to the CNT, any polymer can be used irrespective of a molecular weight, a molecular weight distribution and a structure.

Examples of a method by which the conjugated polymer adheres to the CNT include (I) a method of adding the CNTs to a melted conjugated polymer and mixing them, (II) a method in which the conjugated polymer is dissolved in a solvent, and the CNTs are added to the solution and the resulting mixture is mixed, (III) a method in which the conjugated polymer is added to a solvent containing the CNTs previously dispersed therein with ultrasonic action or the like and the resulting mixture is mixed, and (IV) a method in which the conjugated polymer and the CNTs are put in a solvent and this mixture system is irradiated with ultrasonic waves to be mixed. In the present invention, plural methods may be used in combination.

In the present invention, a length of the CNT is preferably shorter than a distance (channel length) between the source electrode and the drain electrode. Depending on the channel length, an average length of the CNT is preferably 2 μm or less, and more preferably 0.5 μm or less. Since in general, commercially available CNTs have a distribution of length and the CNTs longer than the channel length may be included, it is preferred to add a step of making the length of the CNT shorter than the channel length. For example, a method of cutting the CNTs into short fibers by an acid treatment by nitric acid or sulfuric acid, an ultrasonic wave treatment, or a freeze-pulverizing method, is effective. It is more preferred in point of improving the purity to use these methods in conjunction with the separation by a filter.

Further, a diameter of the CNT is not particularly limited; however, it is preferably not less than 1 nm and not more than 100 nm, and more preferably not more than 50 nm.

In the present invention, it is preferred to provide a step of dispersing uniformly the CNTs in a solvent and filtering a dispersion with a filter. By obtaining the CNTs smaller than a filter pore size by filtration, CNTs shorter than the channel length can be obtained efficiently. In this case, a membrane filter is preferably used as a filter. A pore size of the filter to be used for filtration may be smaller than the channel length and is preferably 0.5 to 10 μm.

Examples of the above-mentioned conjugated polymer covering the CNT include polythiophene-based polymers, polypyrrole-based polymers, polyaniline-based polymers, polyacetylene-based polymers, poly-p-phenylene-based polymers, poly(p-phenylene vinylene)-based polymers, and thiophene-heteroarylene-based polymers having a thiophene unit and a heteroaryl unit in a repeating unit, and two or more thereof may be used. As the above-mentioned polymers, polymers in which a single monomer unit is lined are preferably used, and polymers obtained by block copolymerization of, random copolymerization of, or graft polymerization of different monomer units, can be used.

Further, a mixture of the CNT composite and the organic semiconductor may be used for the semiconductor layer 4. By uniformly dispersing the CNT composite in the organic semiconductor, it becomes possible to realize high mobility while maintaining characteristics of the organic semiconductor itself.

The content of the CNT composite in the semiconductor layer containing the CNT composite and the organic semiconductor is preferably not less than 0.01 part by weight and not more than 3 parts by weight, and more preferably not more than 1 part by weight with respect to 100 parts by weight of the organic semiconductor.

Further, the semiconductor layer 4 may further contain an insulating material. Examples of the insulating material

to be used herein include the insulating material composition of the present invention, and polymer materials such as poly(methyl methacrylate), polycarbonate and polyethylene terephthalate; however, the insulating material is not particularly limited to these materials.

The semiconductor layer 4 may be a monolayer or plural layers, and its thickness is preferably 1 nm or more and 200 nm or less, and more preferably 100 nm or less. By having a film thickness within this range, it becomes easy to form a uniform thin film, and it is possible to suppress the current between source and drain which cannot be controlled by a gate voltage and enhance the on/off ratio of the FET more. The film thickness can be measured by an atomic force microscope or an ellipsometric method.

As a method of forming the semiconductor layer 4, dry methods such as a resistance heating evaporation method, an electron beam method, a sputtering method and a CVD method can be employed; however, an application method is preferably used from the viewpoint of the production cost or the adaptability for large area. As the application method, the same method as in the aforementioned description of the composition can be used, and an application method can be selected according to aimed coat characteristics such as controls of a coat thickness or orientation. Further, a formed coat may be subjected to an annealing treatment at an atmospheric pressure or under a reduced pressure or in an atmosphere of inert gas (in an atmosphere of nitrogen or argon).

Further, an oriented layer may also be provided between the gate insulating layer 3 and the semiconductor layer 4. As the oriented layer, publicly known materials, such as silane compounds, titanium compounds, organic acids and heteroorganic acids, can be used, and organic silane compounds are particularly preferable. The organic silane compound is not particularly limited, and specific examples of the organic silane compounds include phenyltrichlorosilane, naphthyltrichlorosilane, anthracenetrichlorosilane, pyrenetrichlorosilane, perylenetrichlorosilane, coronenetrichlorosilane, thiophenetrichlorosilane, pyrroletrichlorosilane, pyridinetrichlorosilane, phenyltrimethoxysilane, phenyltriethoxysilane, naphthyltrimethoxysilane, naphthyltriethoxysilane, anthracenetrimethoxysilane, anthracenetriethoxysilane, pyrenetrimethoxysilane, pyrenetriethoxysilane, thiophenetrimethoxysilane, thiophenetriethoxysilane, phenylmethyltrichlorosilane, phenylethyltrichlorosilane, phenylpropyltrichlorosilane, phenylbutyltrichlorosilane, phenylhexyltrichlorosilane, phenyloctyltrichlorosilane, naphthylmethyltrichlorosilane, naphthylethyltrichlorosilane, anthracenemethyltrichlorosilane, anthraceneethyltrichlorosilane, pyrenemethyltrichlorosilane, pyreneethyltrichlorosilane, thiophenemethyltrichlorosilane, thiopheneethyltrichlorosilane, aminophenyltrichlorosilane, hydroxyphenyl trichlorosilane, chlorophenyltrichlorosilane, dichlorophenyltrichlorosilane, trichlorophenyltrichlorosilane, bromophenyltrichlorosilane, fluorophenyltrichlorosilane, difluorophenyltrichlorosilane, trifluorophenyltrichlorosilane, tetrafluorophenyltrichlorosilane, pentafluorophenyltrichlorosilane, iodophenyltrichlorosilane, and cyanophenyltrichlorosilane.

The oriented layer is preferably composed of a monomolecular layer or an aggregate of molecules, containing the organic silane compound, and in consideration of resistance of the oriented layer, a film thickness of the oriented layer is preferably10 nm or less, and more preferably a monomolecular film. Further, the oriented layer containing silane compounds also includes a substance formed by chemical bonding between a functional group in the silane compound and the surface of the gate insulating layer. A closely packed and robust film can be formed when the functional group (for example, a trichlorosilyl group) is chemically reacted with the surface of the gate insulating layer. When an unreacted silane compound is layered on the reacted robust film, it is possible to remove the unreacted silane compound by washing to obtain a monomolecular film formed by chemical bonding between the functional group and the surface of the gate insulating layer.

A method of forming the oriented layer is not particularly limited, and examples thereof include vapor phase methods such as a CVD method; and methods of using a liquid phase such as a spin coating and an immersion and withdrawal method.

Before forming the oriented layer, the surface of the gate insulating layer which is a substratum of the oriented layer may be subjected to a hydrophilization treatment using a UV/ozone method or an oxygen plasma method. This treatment allows a chemical reaction between the functional group and the surface of the gate insulating layer to occur readily.

In the present invention, the FET may have a second insulating layer on the opposite side of the gate insulating layer with respect to the semiconductor layer 4. Herein, the opposite side of the gate insulating layer with respect to the semiconductor layer refers to, for example, a lower side of the semiconductor layer when having the gate insulating layer on an upper side of the semiconductor layer. This arrangement allows a voltage of the threshold value or hysteresis to decrease and therefore a high performance FET is obtained. The material to be used in the second insulating layer is not particularly limited, and specific examples thereof include inorganic materials such as silicon oxide and alumina; polymer materials such as polyimide and derivatives thereof, polyvinyl alcohol, polyvinyl chloride, polyethylene terephthalate, poly(vinylidene fluoride), polysiloxane and derivatives thereof, and polyvinylphenol and derivatives thereof; and a mixture of an inorganic material powder and the polymer material, and a mixture of an organic low molecular material and the polymer material. Among these materials, it is preferred to use the polymer material of which the insulating layer can be made by the application method such as an ink-jet method. Particularly, when polyfluoroethylene, polynorbornene, polysiloxane, polyimide, polystyrene, polycarbonate or derivatives thereof, polyacrylic acid derivatives, polymethacrylic

acid derivatives, or copolymers containing these compounds are used, since the effect of reducing the voltage of the threshold value and the hysteresis is larger, they are preferred, and polyacrylic acid derivatives, polymethacrylic acid derivatives, or copolymers containing these are particularly preferred.

A film thickness of the second insulating layer is commonly 50 nm to 10 μm, and preferably 100 nm to 3 μm. The second insulating layer may be a monolayer or plural layers. Further, one layer may be formed of a plurality of insulating materials, or may be formed by laminating a plurality of insulating materials.

A method of forming the second insulating layer 7 is not particularly limited, and dry methods such as a resistance heating evaporation method, an electron beam method, a sputtering method and a CVD method can be employed; however, an application method is preferably used from the viewpoint of the production cost or the adaptability for large area. As the application method, the same method as in the aforementioned description of the composition can be used.

The formed FET can control a current flowing between the source electrode and the drain electrode through changing a gate voltage. The mobility of the FET can be calculated by use of the following formula (a):

$$\mu = (\delta Id/\delta Vg) L \cdot D/(W \cdot \varepsilon_r \cdot \varepsilon \cdot Vsd) \qquad (a)$$

wherein Id is a current between the source and the drain, Vsd is a voltage between the source and the drain, Vg is a gate voltage, D is a thickness of the insulating layer, L is a channel length, W is a channel width, $\varepsilon_r$ is a relative permittivity of the gate insulating layer, and ε is a dielectric constant ($8.85\times10^{-12}$ F/m) in a vacuum.

A voltage of the threshold value can be determined from a point of intersection of an extension line of a linear portion and a Vg axial in an Id-Vg graph. Further, a gate current value at Vg of -20 V has been considered as a leak current.

<Composition>

The composition of the present invention contains (a) a metal chelate represented by the general formula (1), (b) a polymer having a weight average molecular weight of 1000 or more, and (c) a solvent, (b) the polymer having a weight average molecular weight of 1000 or more being contained in an amount of 5 to 90 parts by weight with respect to 100 parts by weight of (a) the metal chelate represented by the general formula (1) :

$$R^1_xM(OR^2)_{y-x} \qquad (1)$$

wherein, $R^1$ represents a monovalent bidentate ligand and in the case of a plurality of $R^1$s, $R^1$s may be the same or different, $R^2$ represents hydrogen, an alkyl group, an acyl group or an aryl group and in the case of a plurality of $R^2$s, $R^2$s may be the same or different, M represents a y-valent metal atom, a value of y is 1 to 6, and x represents an integer of 1 to y.

The monovalent bidentate ligand representing $R^1$ refers to a compound having a group to bind covalently to and a group to coordinate to metal serving as an objection of coordination. Examples of the group to bind covalently include groups which come to be able to bind covalently with the metal atom by deprotonation, such as a hydroxy group, a mercapto group and a carboxyl group. Examples of the group to coordinate include a carbonyl group, a thiocarbonyl group, a nitrile group, an amino group, an imino group, a phosphine oxide group and the like. The number of carbon atoms of $R^1$s is not particularly limited; however, it is preferably 3 or more and 20 or less, and more preferably 3 or more and 12 or less from the viewpoint of thermally-decomposing property during film formation.

The alkyl group in $R^2$ represents, for example, saturated aliphatic hydrocarbon groups such as a methyl group, an ethyl group, an n-propyl group, an isopropyl group, an n-butyl group, a sec-butyl group, tert-butyl group, a cyclopropyl group, a cyclohexyl group, a norbornyl group and an adamantyl group, and these alkyl groups may have a substituent or may have no substituent. An additional substituent in the case of having a substituent is not particularly limited, and examples of the substituent include an alkoxy group and an aryl group, and these additional substituents may further have a substituent. Further, the number of carbon atoms of the alkyl group is not particularly limited; however, it is preferably 1 or more and 20 or less, and more preferably 1 or more and 8 or less from the viewpoint of ease of availability and cost.

The acyl group in the $R^2$ represents functional groups formed by substituting an aliphatic hydrocarbon group or an aromatic group for one side of a carbonyl bond, such as an acetyl group, a hexanoyl group and a benzoyl group, and this aliphatic hydrocarbon group or aromatic group may have a substituent or may have no substituent. The number of carbon atoms of the acyl group is not particularly limited; however, it is preferably within the range of 2 or more and 40 or less.

The aryl group in the $R^2$ represents aromatic hydrocarbon groups such as a phenyl group, a naphthyl group, a biphenyl group, an anthracenyl group, a phenanthryl group, a terphenyl group and a pyrenyl group; and aromatic

heterocyclic groups such as a furanyl group, a thiophenyl group, a benzofuranyl group, a dibenzofuranyl group, a pyridyl group and a quinolinyl group, and these aryl groups may have a substituent or may have no substituent. The number of carbon atoms of the aryl group is not particularly limited; however, it is preferably within the range of 3 or more and 40 or less.

The alkoxy group exemplified as a substituent in the above description represents functional groups formed by substituting an aliphatic hydrocarbon group for one side of an ether bond, such as a methoxy group, an ethoxy group and a propoxy group, and this aliphatic hydrocarbon group may have a substituent or may have no substituent. The number of carbon atoms of the alkoxy group is not particularly limited; however, it is preferably within the range of 1 or more and 20 or less.

The y-valent metal atom is not particularly limited as long as it forms a metal chelate, and examples thereof include magnesium, aluminum, titanium, chromium, manganese, cobalt, nickel, copper, zinc, gallium, zirconium, ruthenium, palladium, indium, hafnium, and platinum. A value of y is 1 to 6 and is determined according to the kind of a metal atom. Among the metal atoms, the metal atom selected from the group consisting of aluminum, titanium, zirconium and indium is preferred from the viewpoint of ease of availability and cost.

Among the metal chelates, an aluminum chelate is preferred, which has excellent stability and is represented by the following general formula (2):

$$R^1_3Al \qquad (2)$$

wherein $R^1$s are the same as the $R^1$s in the general formula (1), and $R^1$s may be the same or different.

In the general formulas (1) and (2), among others, β-diketone derivatives or β-ketoester derivatives are preferred as $R^1$ because they can be obtained at low cost and enable to form a stable chelate.

Specific examples of the β-diketone derivatives include 2,4-pentanedione, 2,4-hexanedione, 2,4-heptanedione, 3,5-heptanedione, 2,4-octanedione, 3,5-octanedione, 2,4-decanedione, 2,4-dodecanedione, 2,6-dimethyl-3,5-heptanedione, 2,2,6-trimethyl-3,5-heptanedione, 2,2,6,6-tetramethyl-3,5-heptanedione, 2,2,6,6-tetramethyl-3,5-octanedione, 3-methyl-2,4-pentanedione, 3-ethyl-3,5-heptanedione, benzoylacetone, dibenzoylmethane, 1-(pyridyl-2-yl)-1,3-butanedione, 1-(pyridyl-2-yl)-2,5-pentanedion, and 1-amino-2,4-pentanedione.

Specific examples of the β-ketoester derivatives include methyl acetoacetate, ethyl acetoacetate, isopropyl acetoacetate, t-butyl acetoacetate, n-butyl acetoacetate, phenyl acetoacetate, ethyl propanoylacetate, ethyl butanoylacetate, ethyl pentanoylacetate, ethyl hexanoylacetate, ethyl octanoylacetate, ethyl decanoylacetate, ethyl dodecanoylacetate, ethyl-2-methylpropanoylacetate, ethyl-2,2-dimethylbutanoylacetate, ethyl benzoylacetate, ethyl-p-anisoylacetate, ethyl-2-pyridyloylacetate, ethyl acrylylacetate, 1-aminobutanoylacetate, and ethyl-α-acetyl propanoate.

In the case of the aluminum chelate represented by the following general formula (2), in consideration of solubility of the chelate in a solvent and stability of the composition, it is preferred that at least one of three $R^1$s in the general formula (2) is different from the other two $R^1$s. For the same reason, it is preferred that at least one of $R^1$s is a β-ketoester derivative.

As the metal chelate represented by the general formula (1) as described above, specifically, the following compounds are exemplified. Examples of the aluminum chelates include diethoxy aluminum (2, 4-pentanedionato), diisopropoxy aluminum (2,4-pentanedionato), diethoxy aluminum (2,4-hexanedionato), diethoxy aluminum (3,5-hexanedionato), diethoxy aluminum (2,4-octanedionato), diethoxy aluminum benzoylacetonate, diethoxy aluminum (1-(pyridyl-2-yl)-1,3-butanedionato), diethoxy aluminum (methyl acetoacetate), diisopropoxy aluminum (methyl acetoacetate), diethoxy aluminum (ethyl acetoacetate), diethoxy aluminum (isopropyl acetoacetate), diethoxy aluminum-(t-butyl acetoacetate), diethoxy aluminum (ethyl butanoylacetate), diethoxy aluminum (ethyl benzoylacetate), ethoxy aluminum bis(2,4-pentanedionato), isopropoxy aluminum bis(2,4-pentanedionato), ethoxy aluminum bis(2,4-hexanedionato), ethoxy aluminum bis(3,5-hexanedionato), ethoxy aluminum bis(2,4-octanedionato), ethoxy aluminum bis(benzoyl acetonato), ethoxy aluminum bis(1-(pyridyl-2-yl)-1,3-butanedionato), ethoxy aluminum bis(ethyl acrylyl acetate), ethoxy aluminum bis(methyl acetoacetate), isopropoxy aluminum bis(methyl acetoacetate), ethoxy aluminum bis(ethyl acetoacetate), ethoxy aluminum bis(isopropyl acetoacetate), ethoxy aluminum bis(t-butyl acetoacetate), ethoxy aluminum bis(ethyl butanoyl acetate), ethoxy aluminum bis(ethyl benzoylacetate), ethoxy aluminum bis (ethyl acrylyl acetate), aluminum tris (2, 4-pentanedionato), aluminum tris(1,3-tetrafluoro-2,4-pentanedionato), aluminum tris(2,4-hexanedionato), aluminum tris(3,5-hexanedionato), aluminum tris(2,4-octanedionato), aluminum tris(benzoyl acetonate), aluminum tris(1-(pyridyl-2-yl)-1,3-butanedionato), aluminum tris(2,6-dimethyl-3,5-heptanedionato), aluminum tris(2,2,6-trimethyl-3,5-heptanedionato), aluminum tris(2,2,6,6-tetramethyl-3,5-octanedionato), aluminum tris(1-amino-2,4-pentanedionato), aluminum tris(methyl acetoacetate), aluminum tris(methyl acetoacetate), aluminum tris(ethyl acetoacetate), aluminum tris(isopropyl acetoacetate), aluminum tris(t-butyl acetoacetate), aluminum tris(ethyl butanoylacetate), aluminum tris(ethyl pentanoylacetate), aluminum tris(ethyl-2-methylpropanoylacetate), aluminum tris(ethyl benzoylacetate), aluminum tris(ethyl-2-pyridyloylacetate), aluminum tris(1-aminobutanoylacetate), aluminum tris(ethyl-α-acetyl propanoate), aluminum tris(ethyl acrylyl acetate), ethoxy aluminum mono(ethyl acetoacetate)mono(isopropyl acetoacetate), ethoxy aluminum

mono(ethyl acetoacetate)mono(3,5-hexanedionato), aluminum bis(ethyl acetoacetate)mono(isopropyl acetoacetate), aluminum bis(ethyl acetoacetate)mono(3,5-hexanedionato), aluminum tris(diethyl malonate), aluminum tris(dioctyl malonate), aluminum tris(diethyl(methyl malonate)), aluminum tris(diethyl(phenyl malonate)), aluminum tris(ethyl thioacetoacetate), aluminum tris(2-acetyl phenolate), and aluminum tris(2-(pyridyl-2-yl)phenolate).

Examples of the zirconium chelates include trisethoxy zirconium (2,4-pentanedionato), trisisopropoxy zirconium (2,4-pentanedionato), trisethoxy zirconium (2,4-hexanedionato), trisethoxy zirconium (3,5-hexanedionato), trisethoxy zirconium benzoylacetonate, trisethoxy zirconium (methyl acetoacetate), trisisopropoxy zirconium (methyl acetoacetate), trisethoxy zirconium (ethyl acetoacetate), trisethoxy zirconium (isopropyl acetoacetate), trisethoxy zirconium-(t-butyl acetoacetate), trisethoxy zirconium (ethyl butanoylacetate), trisethoxy zirconium (ethyl benzoylacetate), diethoxy zirconium bis(2,4-pentanedionato), diisopropoxy zirconium bis(2,4-pentanedionato), diethoxy zirconium bis(2,4-hexanedionato), diethoxy zirconium bis(3,5-hexanedionato), diethoxy zirconium bis(benzoyl acetonato), diethoxy zirconium bis(methyl acetoacetate), diisopropoxy zirconium bis(methyl acetoacetate), diethoxy zirconium bis(ethyl acetoacetate), diethoxy zirconium bis(isopropyl acetoacetate), diethoxy zirconium bis(t-butyl acetoacetate), diethoxy zirconium bis (ethyl butanoyl acetate), diethoxy zirconium bis(ethyl benzoylacetate), ethoxy zirconium tris(2,4-pentanedionato), isopropoxy zirconium tris(2,4-pentanedionato), ethoxy zirconium tris(2,4-hexanedionato), ethoxy zirconium tris(3,5-hexanedionato), ethoxy zirconium tris(benzoylacetonate), ethoxy zirconium tris(methyl acetoacetate), isopropoxy zirconium tris (methyl acetoacetate), ethoxy zirconium tris(ethyl acetoacetate), ethoxy zirconium tris(isopropyl acetoacetate), ethoxy zirconium tris(t-butyl acetoacetate), ethoxy zirconium tris(ethyl butanoylacetate), ethoxy zirconium tris(ethyl benzoylacetate), zirconium tetrakis(2,4-pentanedionato), zirconium tetrakis(2,4-hexanedionato), zirconium tetrakis(3,5-hexanedionato), zirconium tetrakis(benzoyl acetonate), zirconium tetrakis(2,6-dimethyl-3,5-heptanedionato), zirconium tetrakis(2,2,6-trimethyl-3,5-heptanedionato), zirconium tetrakis(methyl acetoacetate), zirconium tetrakis(methyl acetoacetate), zirconium tetrakis(ethyl acetoacetate), zirconium tetrakis(isopropyl acetoacetate), zirconium tetrakis(t-butyl acetoacetate), zirconium tetrakis(ethyl butanoylacetate), zirconium tetrakis(ethyl-2-methylpropanoylacetate), zirconium tetrakis(ethyl benzoylacetate), zirconium tetrakis(diethyl malonate), zirconium tetrakis(diethyl(methyl malonate)), ethoxy zirconium bis(ethyl acetoacetate)mono(isopropyl acetoacetate), ethoxy zirconium bis(ethyl acetoacetate)mono(3,5-hexanedionato), zirconium bis(ethyl acetoacetate)bis(isopropyl acetoacetate), and zirconium tris(ethyl acetoacetate)mono(3,5-hexanedionato).

Examples of the titanium chelates include trisethoxy titanium (2,4-pentanedionato), trisisopropoxy titanium (2,4-pentanedionato), trisethoxy titanium (2,4-hexanedionato), trisethoxy titanium (3,5-hexanedionato), trisethoxy titanium benzoylacetonate, trisethoxy titanium (methyl acetoacetate), trisisopropoxy titanium (methyl acetoacetate), trisethoxy titanium (ethyl acetoacetate), trisethoxy titanium (isopropyl acetoacetate), trisethoxy titanium (t-butyl acetoacetate), trisethoxy titanium (ethyl butanoylacetate), trisethoxy titanium (ethyl benzoylacetate), diethoxy titanium bis(2,4-pentanedionato), diisopropoxy titanium bis(2,4-pentanedionato), diethoxy titanium bis(2,4-hexanedionato), diethoxy titanium bis(3,5-hexanedionato), diethoxy titanium bis(benzoyl acetonato), diethoxy titanium bis(methyl acetoacetate), diisopropoxy titanium bis(methyl acetoacetate), diethoxy titanium bis(ethyl acetoacetate), diethoxy titanium bis(isopropyl acetoacetate), diethoxy titanium bis(t-butyl acetoacetate), diethoxy titanium bis (ethyl butanoyl acetate), diethoxy titanium bis(ethyl benzoylacetate), ethoxy titanium tris(2,4-pentanedionato), isopropoxy titanium tris(2,4-pentanedionato), ethoxy titanium tris(2,4-hexanedionato), ethoxy titanium tris(3,5-hexanedionato), ethoxy titanium tris(benzoylacetonate), ethoxy titanium tris(methyl acetoacetate), isopropoxy titanium tris (methyl acetoacetate), ethoxy titanium tris(ethyl acetoacetate), ethoxy titanium tris(isopropyl acetoacetate), ethoxy titanium tris(t-butyl acetoacetate), ethoxy titanium tris(ethyl butanoylacetate), ethoxy titanium tris(ethyl benzoylacetate), titanium tetrakis(2,4-pentanedionato), titanium tetrakis(2,4-hexanedionato), titanium tetrakis(3,5-hexanedionato), titanium tetrakis(benzoyl acetonate), titanium tetrakis(2,6-dimethyl-3,5-heptanedionato), titanium tetrakis(2,2,6-trimethyl-3,5-heptanedionato), titanium tetrakis(methyl acetoacetate), titanium tetrakis(methyl acetoacetate), titanium tetrakis(ethyl acetoacetate), titanium tetrakis(isopropyl acetoacetate), titanium tetrakis(t-butyl acetoacetate), titanium tetrakis(ethyl butanoylacetate), titanium tetrakis(ethyl-2-methylpropanoylacetate), titanium tetrakis(ethyl benzoylacetate), titanium tetrakis(diethyl malonate), titanium tetrakis(dioctyl malonate), titanium tetrakis (diethyl (methyl malonate)), ethoxy titanium bis (ethyl acetoacetate)mono(3,5-hexanedionato), titanium bis(ethyl acetoacetate)bis(isopropyl acetoacetate), and titanium tris(ethyl acetoacetate)mono(3,5-hexanedionato).

Examples of the indium chelates include diethoxy indium (2,4-pentanedionato), diisopropoxy indium (2,4-pentanedionato), diethoxy indium (2,4-hexanedionato), diethoxy indium (3,5-hexanedionato), diethoxy indium benzoylacetonate, diethoxy indium (methyl acetoacetate), diisopropoxy indium (methyl acetoacetate), diethoxy indium (ethyl acetoacetate), diethoxy indium (isopropyl acetoacetate), diethoxy indium (t-butyl acetoacetate), diethoxy indium (ethyl butanoylacetate), diethoxy indium (ethyl benzoylacetate), ethoxy indium bis (2, 4-pentanedionato), isopropoxy indium bis(2,4-pentanedionato), ethoxy indium bis(2,4-hexanedionato), ethoxy indium bis(3,5-hexanedionato), ethoxy indium bis (benzoyl acetonato), ethoxy indium bis (methyl acetoacetate), isopropoxy indium bis(methyl acetoacetate), ethoxy indium bis(ethyl acetoacetate), ethoxy indium bis(isopropyl acetoacetate), ethoxy indium bis(t-butyl acetoacetate), ethoxy indium bis(ethyl butanoyl acetate), ethoxy indium bis(ethyl benzoylacetate), indium tris(2,4-pentanedionato), indium tris(2,4-hexanedionato), indium tris(3,5-hexanedionato), indium tris(benzoylacetonate), indium tris(2,6-dimethyl-3,5-heptanedionato), indium tris(2,2,6-trimethyl-3,5-heptanedionato), indium tris(methyl acetoacetate), indium tris(methyl acetoacetate), indium tris(ethyl acetoacetate), indium tris(isopropyl acetoacetate), indium tris(t-butyl acetoacetate), indium tris(ethyl butanoylacetate), indium tris(ethyl-2-methylpropanoylacetate), indium tris(ethyl benzoylacetate), indium tris(diethyl malonate), indium tris(dioctyl malonate), and indium tris(diethyl(methyl malonate)).

Examples of the magnesium chelates include magnesium bis(2,4-pentanedionato) and magnesium bis(ethyl acetoacetate).

Examples of the chromium chelates include chromium tris(2,4-pentanedionato) and chromium tris(ethyl acetoacetate).

Examples of the manganese chelates include manganese (II) bis(2,4-pentanedionato), manganese (II) bis(ethyl acetoacetate), manganese (III) tris(2,4-pentanedionato) and manganese (III) tris(ethyl acetoacetate).

Examples of the cobalt chelates include cobalt tris (2, 4-pentanedionato) and cobalt tris (ethyl acetoacetate).

Examples of the nickel chelates include nickel bis(2,4-pentanedionato) and nickel bis(ethyl acetoacetate).

Examples of the copper chelates include copper bis(2,4-pentanedionato) and copper bis(ethyl acetoacetate).

Examples of the zinc chelates include zinc bis(2,4-pentanedionato), zinc bis(ethyl acetoacetate), and gallium tris(2,4-pentanedionato).

Examples of the gallium chelates include gallium tris(ethyl acetoacetate).

Examples of the ruthenium chelates include ruthenium tris(2,4-pentanedionato) and ruthenium tris(ethyl acetoacetate).

Examples of the palladium chelates include palladium bis(2,4-pentanedionato) and palladium bis(ethyl acetoacetate).

Examples of the hafnium chelates include hafnium tetrakis(2,4-pentanedionato) and hafnium tetrakis(ethyl acetoacetate).

Examples of the platinum chelates include platinum bis(2,4-pentanedionato) and platinum bis (ethyl acetoacetate).

(a) The metal chelate represented by the general formula (1) can be obtained, for example, by the following method. When a specified amount of a ligand is added dropwise to metal alkoxide and then an alcohol component derived from alkoxide is distilled off by heating/refluxing, and thereby a desired metal chelate can be synthesized. Further, when two or more kinds of ligands are added dropwise in order, a metal chelate having different ligands is attained.

The composition of the present invention contains (b) a polymer having a weight average molecular weight of 1000 or more. The weight average molecular weight (Mw) is a value on the polystyrene equivalent basis measured by GPC (Gel Permeation Chromatography). When Mw is smaller than 1000, the effect on a film forming property decreases and it is difficult to form a good-quality film. When Mw is larger, it is preferred since the film-forming property is higher. However, when Mw is too large, it is concerned that filter permeability may be deteriorated in an application process. Accordingly, Mw is preferably 500000 or less, and more preferably 200000 or less.

Further, the content of (b) the polymer having a weight average molecular weight of 1000 or more in the composition of the present invention is within the range of 5 to 90 parts by weight with respect to 100 parts by weight of (a) the metal chelate represented by the general formula (1). When the content of (b) the polymer is within the range, a good film-forming property can be secured, and it is possible to pursue, simultaneously, a low voltage of the threshold value and a low leak current in applying the composition to the gate insulating film of the FET. When the content of (b) the polymer having a weight average molecular weight of 1000 or more is more than 90 parts by weight, it is impossible to pursue, simultaneously, a low voltage of the threshold value and a low leak current in applying the composition to the gate insulating film of the FET, and conversely, when the content is less than 5 parts by weight, the film-forming property is deteriorated and it is difficult to obtain a good-quality insulating film. More preferably, the content of (b) the polymer having a weight average molecular weight of 1000 or more is within the range of 5 to 60 parts by weight with respect to 100 parts by weight of (a) the metal chelate represented by the general formula (1) . When the content of the polymer is set to 60 parts by weight or less, the effect of reducing a leak current is larger. Moreover preferably, the content of (b) the polymer having a weight average molecular weight of 1000 or more is within the range of 10 to 60 parts by weight with respect to 100 parts by weight of (a) the metal chelate represented by the general formula (1). When the content of the polymer is set to 10 parts by weight or more, a film thickness required for reducing leakage can be ensured without increasing the number of processes. Moreover preferably, the content of (b) the polymer having a weight average molecular weight of 1000 or more is within the range of 10 to 30 parts by weight with respect to 100 parts by weight of (a) the metal chelate represented by the general formula (1). When the content of the polymer is set to 30 parts by weight or less, the effect of reducing a voltage of the threshold value is more remarkable.

(b) The polymer having a weight average molecular weight of 1000 or more preferably has, in a repeating unit, at least one group selected from the group consisting of a hydroxy group, a silanol group, a carboxyl group, an amino group and a mercapto group. These functional groups enable to form a robust film suppressing a leak current and having excellent solvent resistance since each of the functional groups reacts with the metal chelate in thermal curing. Specific examples of such a polymer include cellulose, polyethylene oxide, polysiloxane, polyimide, polyvinyl alcohol, polyvinyl

phenol, polystyrene, polyamide, polycarbonate, fluorine-substituted polyethylene and derivatives thereof, polyacrylic acid derivatives, polymethacrylic acid derivatives, and copolymers containing them. Among these polymers, polysiloxane is more preferred since it has a high insulating property and can be cured at low temperatures.

Among the polysiloxane, particularly preferred one is the polysiloxane containing, as copolymerization components, at least a silane compound represented by the general formula (3) and an epoxy group-containing silane compound represented by the general formula (4):

$$R^3_mSi(OR^4)_{4-m} \qquad (3)$$

wherein $R^3$ represents hydrogen, an alkyl group, a heterocyclic group, an aryl group or an alkenyl group and in the case of a plurality of $R^3$s, $R^3$s may be the same or different, $R^4$ represents hydrogen, an alkyl group, an acyl group or an aryl group and in the case of a plurality of $R^4$s, $R^4$s may be the same or different, and m represents an integer of 1 to 3; and

$$R^5_nR^6_lSi(OR^7)_{4-n-l} \qquad (4)$$

wherein $R^5$ represents an alkyl group having one or more epoxy group in a part of its chain and in the case of a plurality of $R^5$s, $R^5$s may be the same or different, $R^6$ represents hydrogen, an alkyl group, a heterocyclic group, an aryl group or an alkenyl group and in the case of a plurality of $R^6$s, $R^6$s may be the same or different, $R^7$ represents hydrogen, an alkyl group, an acyl group or an aryl group and in the case of a plurality of $R^7$s, $R^7$s may be the same or different, 1 is an integer of 0 to 2, and n represents 1 or 2, satisfying $1 + n \leq 3$.

The descriptions of the alkyl group, the acyl group and the aryl group in $R^5$ to $R^7$ are similar to those of $R^2$ described above.

The heterocyclic group in $R^3$ and $R^6$ represents groups derived from an aliphatic ring, which has atoms other than carbon in the ring, such as a pyran ring, a piperidine ring and an amido ring, and these heterocyclic groups may have a substituent or may have no substituent. The number of carbon atoms of the heterocyclic group is not particularly limited; however it is preferably within the range of 2 or more and 20 or less.

The alkenyl group in $R^3$ and $R^6$ represents unsaturated aliphatic hydrocarbon groups containing a double bond such as a vinyl group, an allyl group and a butadienyl group, and this alkenyl group may have a substituent or may have no substituent. The number of carbon atoms of the alkenyl group is not particularly limited; however, it is preferably within the range of 2 or more and 20 or less.

The alkyl group having an epoxy groups in a part of a chain, for $R^5$, represents an alkyl group having, in a part of a chain, a three-membered ether structure which is formed by coupling of adjacent two carbon atoms with one oxygen atom. This includes both of the case in which adjacent two carbon atoms contained in a main chain, the longest continuous carbon linkage in the alkyl group, are used, and the case in which adjacent two carbon atoms contained in the so-called side chain other than the main chain are used.

By introducing a silane compound represented by the general formula (3) as copolymerization components of the polysiloxane, it is possible to form an insulating film which enhances an insulating property and chemical resistance of a film obtained with use of the composition while maintaining high transparency in a visible light region, and produces fewer traps within an insulating film, which cause hysteresis in applying the composition to a gate insulating film of an FET.

Further, when at least one of m $R^3$s in the general formula (3) is an aryl group, it is preferred since flexibility of the insulating film is improved and the occurrence of cracks can be prevented.

Specific examples of the silane compounds represented by the general formula (3) to be used in the present invention include vinyltrimethoxysilane, vinyltriethoxysilane, 3-methacryloxypropyltrimethoxysilane, 3-methacryloxypropyltriethoxysilane, methyltrimethoxysilane, methyltriethoxysilane, ethyltrimethoxysilane, ethyltriethoxysilane, propyltrimethoxysilane, propyltriethoxysilane, hexyltrimethoxysilane, octadecyltrimethoxysilane, octadecyltriethoxysilane, phenyltrimethoxysilane, phenyltriethoxysilane, p-tolyltrimethoxysilane, benzyltrimethoxysilane, α-naphthyltrimethoxysilane, β-naphthyltrimethoxysilane, 3-aminopropyltriethoxysilane, N-(2-aminoethyl)-3-aminopropyltrimethoxysilane, 3-chloropropyltrimethoxysilane, dimethyldimethoxysilane, dimethyldiethoxysilane, diphenyldimethoxysilane, diphenyldiethoxysilane, methylphenyldimethoxysilane, methylvinyldimethoxysilane, methylvinyldiethoxysilane, 3-aminopropylmethyldimethoxysilane, N-(2-aminoethyl)-3-aminopropylmethyldimethoxysilane, 3-chloropropylmethyldimethoxysilane, 3-chloropropylmethyldiethoxysilane, cyclohexylmethyldimethoxysilane, 3-methacryloxypropyldimethoxysilane, octadecylmethyldimethoxysilane, trimethoxysilane, trifluoroethyl trimethoxysilane, trifluoroethyl triethoxysilane, trifluoroethyl triisopropoxysilane, trifluoropropyltrimethoxysilane, trifluoropropyltriethoxysilane, trifluoropropyltriisopropoxysilane, heptadecafluorodecyl trimethoxysilane, heptadecafluorodecyl triethoxysilane, heptadecafluorodecyl triisopropoxysilane, tridecafluorooctyl triethoxysilane, tridecafluorooctyl trimethoxysilane, tridecafluorooctyl triisopropoxysilane, trifluoroethylmethyl dimethoxysilane, trifluoroethylmethyl diethoxysilane, trifluoroethylmethyl diisopropoxysilane, trifluoropropylmethyl dimethoxysilane, trifluoropropylmethyl diethoxysilane, trifluoropropylmethyl diisopropoxysilane, heptadecafluorodecyl methyldimethoxysilane, heptadecafluorodecyl methyldiethoxysilane, heptadecafluorodecyl methyldiisopropoxysilane, tridecafluorooctyl methyldimethoxysilane, tridecafluorooctyl methyldiethoxysilane, tridecafluorooctyl methyldiisopropoxysilane, trifluoroethylethyl dimethoxysilane, trifluoroethylethyl diethoxysilane, trifluoroethylethyl diisopropoxysilane, trifluoropropylethyl dimethoxysilane, trifluoropropylethyl diethoxysilane, trifluoropropylethyl diisopropoxysilane, heptadecafluorodecyl ethyldimethoxysilane, heptadecafluorodecyl ethyldiethoxysilane, heptadecafluorodecyl ethyldiisopropoxysilane, tridecafluorooctyl ethyldiethoxysilane, tridecafluorooctyl ethyldimethoxysilane, tridecafluorooctyl ethyldiisopropoxysilane, and p-trifluorophenyltriethoxysilane.

It is preferred for increasing a crosslinking density and for improving chemical resistance and an insulating property to use, among the above-mentioned silane compounds, vinyltrimethoxysilane, vinyltriethoxysilane, methyltrimethoxysilane, methyltriethoxysilane, ethyltrimethoxysilane, ethyltriethoxysilane, propyltrimethoxysilane, propyltriethoxysilane, hexyltrimethoxysilane, octadecyltrimethoxysilane, octadecyltriethoxysilane, phenyltrimethoxysilane, p-tolyltrimethoxysilane, benzyltrimethoxysilane, α-naphthyltrimethoxysilane, β-naphthyltrimethoxysilane, trifluoroethyl trimethoxysilane, trimethoxysilane, or p-trifluorophenyltriethoxysilane, in which m in the general formula (3) is 1. Further, it is particularly preferred from the viewpoint of the ability of mass production to use vinyltrimethoxysilane, methyltrimethoxysilane, ethyltrimethoxysilane, propyltrimethoxysilane, hexyltrimethoxysilane, octadecyltrimethoxysilane, octadecyltrimethoxysilane, phenyltrimethoxysilane, p-tolyltrimethoxysilane, benzyltrimethoxysilane, α-naphthyltrimethoxysilane, β-naphthyltrimethoxysilane, trifluoroethyl trimethoxysilane, or trimethoxysilane, in which $R^2$ is a methyl group.

Preferred examples include a combination of two or more silane compounds represented by the general formula (3). Among others, a combination of a silane compound having an alkyl group and a silane compound having an aryl group is particularly preferred since this combination can pursue a high insulating property and flexibility for preventing the occurrence of cracks simultaneously.

By introducing the epoxy group-containing silane compound represented by the general formula (4) as the copolymerization components of the polysiloxane, the ability of a resist or a semiconductor coating solution to be applied onto the insulating film can be better.

Specific examples of the epoxy group-containing silane compound represented by the general formula (4) to be used in the present invention include γ-glycidoxypropyltrimethoxysilane, β-(3,4-epoxycyclohexyl)ethyltrimethoxysilane, γ-glycidoxypropyltriethoxysilane, β-(3,4-epoxycyclohexyl)ethyltriethoxysilane, γ-glycidoxypropyltriisopropoxysilane, β-(3,4-epoxycyclohexyl)ethyltriisopropoxysilane, γ-glycidoxypropylmethyldimethoxysilane, β-(3,4-epoxy cyclohexyl)ethylmethyldimethoxysilane, γ-glycidoxypropylmethyldiethoxysilane, β-(3,4-epoxy cyclohexyl)ethylmethyldiethoxysilane, γ-glycidoxypropylmethyldiisopropoxysilane, β-(3,4-epoxycyclohexyl)ethylmethyldiisopropoxysilane, γ-glycidoxypropylethyldimethoxysilane, β-(3,4-epoxy cyclohexyl)ethylethyldimethoxysilane, γ-glycidoxypropylethyldiethoxysilane, β-(3,4-epoxy cyclohexyl)ethylethyldiethoxysilane, γ-glycidoxypropylethyldiisopropoxysilane, β-(3,4-epoxy cyclohexyl)ethylethyldiisopropoxysilane, β-(3,4-epoxy cyclohexyl)propyltrimethoxysilane, and γ-glycidoxyethyltrimethoxysilane.

It is preferred for increasing a crosslinking density and for improving chemical resistance and an insulating property to use, among these compounds, γ-glycidoxypropyltrimethoxysilane, β-(3,4-epoxycyclohexyl)ethyltrimethoxysilane, γ-glycidoxypropyltriethoxysilane, β-(3,4-epoxycyclohexyl)ethyltriethoxysilane, γ-glycidoxypropyltriisopropoxysilane, β-(3,4-epoxycyclohexyl)ethyltriisopropoxysilane, β-(3,4-epoxy cyclohexyl)propyltrimethoxysilane, and γ-glycidoxyethyltrimethoxysilane, in which n is 1 and 1 is 0 in the general formula (4). It is particularly preferred from the viewpoint of the ability of mass production to use γ-glycidoxypropyltrimethoxysilane, β-(3,4-epoxycyclohexyl)ethyltrimethoxysilane, β-(3,4-epoxy cyclohexyl)propyltrimethoxysilane and γ-glycidoxyethyltrimethoxysilane, in which $R^7$ is a methyl group.

The polysiloxane can contain other silane compounds besides the silane compounds represented by the general formulas (3) or (4) as the copolymerization components. Examples of other silane compounds include diethoxydimethylsilane, diethoxydiphenylsilane, tetramethoxysilane, tetraethoxysilane and the like.

Further, it is preferred that the content of a constituent unit, which is derived from the epoxy group-containing silane compound represented by the general formula (4) in the polysiloxane, is 0.1 to 40 mol % with respect to a total constituent unit of the silane compounds which are copolymerization components of the polysiloxane. When the content of the constituent unit is 0.1 mol % or more, good coatability, in which cissing of the organic semiconductor coating solution is suppressed, can be attained, and the content of the constituent unit is more preferably 1 mol % or more.

The polysiloxane can be obtained, for example, by the following method. All silane compounds including the epoxy group-containing silane compound are dissolved in a solvent, and to this, an acid catalyst and water are added over 1 to 180 minutes, and then the silane compounds are hydrolyzed at a temperature of from room temperature to 80°C for 1 to 180 minutes. A temperature during the hydrolysis reaction is more preferably room temperature to 55°C. The reaction solution is heated at temperatures between 50°C and a boiling point of the solvent for 1 to 100 hours to perform a condensation reaction to obtain an epoxy group-containing polysiloxane. In this case, since diol is formed by adding water to the epoxy group in the epoxy group-containing silane compound represented by the general formula (4), it is necessary to add water equivalent or more to the epoxy group in addition to the water equivalent to the alkoxyl group in the total silane compounds.

The fact that the composition contains (a) a metal chelate represented by the general formula (1) and (b) a

polymer having a weight average molecular weight of 1000 or more can be determined by using various organic and inorganic analysis techniques such as elemental analysis, nuclear magnetic resonance analysis, infrared spectroscopic analysis and X-ray photoelectron spectroscopy singly or in combination of two or more of them.

(c) The solvent is not particularly limited, and specific examples thereof include ethers such as ethylene glycol monomethyl ether, ethylene glycol monoethyl ether, propylene glycol monomethyl ether, propylene glycol monoethyl ether, propylene glycol mono n-butyl ether, propylene glycol mono t-butyl ether, ethylene glycol dimethyl ether, ethylene glycol diethyl ether, ethylene glycol dibutyl ether and diethylene glycol ethyl methyl ether; acetates such as ethylene glycol monoethyl ether acetate, propylene glycol monomethyl ether acetate, propyl acetate, butyl acetate, isobutyl acetate, 3-methoxybutyl acetate, 3-methyl-3-methoxybutyl acetate, methyl lactate, ethyl lactate and butyl lactate; ketones such as acetylacetone, methyl propyl ketone, methyl butyl ketone, methyl isobutyl ketone, cyclopentanone and 2-heptanone; alcohols such as butyl alcohol, isobutyl alcohol, pentanol, 4-methyl-2-pentanol, 3-methyl-2-butanol, 3-methyl-3-methoxybutanol and diacetone alcohol; and aromatic hydrocarbons such as toluene and xylene. These solvents may be used singly, or may be used in combination of two or more thereof.

The composition of the present invention preferably further contains (d) a tetrafunctional silane, or tetrafunctional silane oligomer obtained by hydrolyzation and condensation of tetrafunctional silane (hereinafter, referred to as "tetrafunctional silane or tetrafunctional silane oligomer"). By containing the tetrafunctional silane or tetrafunctional silane oligomer, a high density film can be formed at lower temperature. Specific examples of the tetrafunctional silane include tetramethoxy silane, tetraethoxy silane, tetraisopropoxy silane, and tetra-t-butoxy silane. Specific examples of the tetrafunctional silane oligomer include Methyl Silicate 51, Methyl Silicate 53A, Ethyl Silicate 40, Ethyl Silicate 48, EMS 485 (every trade name, produced by COLCOAT CO., LTD.), M Silicate 51 (trade name, produced by TAMA CHEMICALS CO. , LTD.).

The composition of the present invention may further contains (e) particles. (e) The particle preferably has a particle diameter of 100 nm or less and more preferably 50 nm or less from the viewpoint of a planarization property of the gate insulating film. The particle diameter indicates an average particle diameter in terms of number average, and the particles are fired after drying, a specific surface area of the resulting particles are measured, and then the average particle diameter is determined from the specific surface area assuming that the particle is a sphere. Equipment to be used for measuring the average particle diameter is not particularly limited and for example, ASAP 2020 (manufactured by Micromeritics Instrument Corp.) can be employed. Further, the particle is preferably in a state of sol from the viewpoint of compatibility with the polysiloxane. Specific examples of (e) the particles include silica particles, titania particles, barium titanate particles, zirconia particles, and barium sulfate particles.

The composition of the present invention may further contain (f) a compound to generate an acid by light (hereinafter, referred to as "photo acid generating agent"). Examples of the photo acid generating agent include onium salt compounds, halogen-containing compounds, diazoketone compounds, diazomethane compounds, sulfone compounds, sulfonic acid ester compounds, sulfone imide compounds and the like.

Specific examples of the onium salt compounds include diazonium salts, ammonium salts, iodonium salts, sulfonium salts, phosphonium salts, oxonium salts and the like. Preferred onium salts include diphenyliodonium triflate, diphenyliodonium pyrenesulfonate, diphenyliodonium dodecylbenzenesulfonate, triphenylsulfonium triflate (trade name "TPS-105" produced by Midori Kagaku Co., Ltd.), 4-t-butylphenyldiphenylsulfonium triflate (trade name "WPAG-339" produced by Wako Pure Chemical Industries, Ltd.), 4-methoxyphenyldiphenylsulfonium triflate (trade name "WPAG-370" produced by Wako Pure Chemical Industries, Ltd.), triphenylsulfonium nonaflate (trade name "TPS-109" produced by Midori Kagaku Co., Ltd.), triphenylsulfonium hexafluoroantimonate, triphenylsulfonium naphthalenesulfonate, (hydroxyphenyl)benzylmethylsulfonium toluenesulfonate, and the like.

Specific examples of the halogen-containing compound include haloalkyl group-containing hydrocarbon compounds and haloalkyl group-containing heterocyclic compounds. Preferred halogen-containing compounds include 1,1-bis(4-chlorophenyl)-2,2,2-trichloroethane, 2-phenyl-4,6-bis(trichloromethyl)-s-triazine, 2-naphthyl-4,6-bis(trichloromethyl)-s-triazine, and the like.

Specific examples of the diazoketone compounds include 1,3-diketo-2-diazo compounds, diazobenzoquinone compounds, diazonaphthoquinone compounds, and the like. Preferred diazoketone compounds include the ester obtained from 1,2-naphthoquinonediazide-4-sulfonic acid and 2,2,3,4,4'-tetrahydroxybenzophenone, the ester obtained from 1,2-naphthoquinonediazide-4-sulfonic acid and 1,1,1-tris(4-hydroxyphenyl)ethane, and the like.

Specific examples of the diazomethane compound include bis(trifluorormethylsulfonyl)diazomethane, bis(cyclohexylsulfonyl)diazomethane, bis(phenylsulfonyl)diazomethane, bis(p-tolylsulfonyl)diazomethane, bis(2,4-xylylsulfonyl)diazomethane, bis(p-chlorophenylsulfonyl)diazomethane, methylsulfonyl-p-toluenesulfonyldiazomethane, cyclohexylsulfonyl(1,1-dimethylethylsulfonyl)diazomethane, bis(1,1-dimethylethylsulfonyl)diazomethane, phenylsulfonyl(benzoyl)diazomethane, and the like.

Specific examples of the sulfone compounds include β-ketosulfone compounds, β-sulfonylsulfone compounds, and the like. Preferred compounds include 4-trisphenacylsulfone, mesitylphenacylsulfone, bis(phenylsulfonyl)methane, and the like.

Examples of the sulfonic acid ester compounds include alkylsulfonic acid esters, haloalkylsulfonic acid esters,

arylsulfonic acid esters, iminosulfonates, and the like. Specific examples of the sulfonic acid ester compounds include benzoin tosylate, pyrogallol trimesylate, nitrobenzyl-9,10-diethoxyanthracene-2-sulfonate, and the like.

Specific examples of the sulfone imide compound include

N-(trifluoromethylsulfonyloxy)succinimide,
N-(trifluoromethylsulfonyloxy)phthalimide,
N-(trifluoromethylsulfonyloxy)diphenylmaleimide,
N-(trifluoromethylsulfonyloxy)bicyclo[2.2.1]hepto-5-ene-2,3 -dicarboxylimide,
N-(trifluoromethylsulfonyloxy)-7-oxabicyclo[2.2.1]hepto-5-e ne-2,3-dicarboxylimide,
N-(trifluoromethylsulfonyloxy)bicyclo[2.2.1]heptane-5,6-oxy -2,3-dicarboxylimide,
N-(trifluoromethylsulfonyloxy)naphthyldicarboxylimide,
N-(camphorsulfonyloxy)succinimide,
N-(camphorsulfonyloxy)phthalimide,
N-(camphorsulfonyloxy)diphenylmaleimide,
N-(camphorsulfonyloxy)bicyclo[2.2.1]hepto-5-ene-2,3-dicarbo xylimide,
N-(camphorsulfonyloxy)-7-oxabicyclo[2.2.1]hepto-5-ene-2,3-d icarboxylimide,
N-(camphorsulfonyloxy)bicyclo[2.2.1]heptane-5,6-oxy-2,3-dic arboxylimide, N-(camphorsulfonyloxy)naphthyldicarboxylimide,
N-(4-metylphenylsulfonyloxy)succinimide,
N-(4-methylphenylsulfonyloxy)phthalimide,
N-(4-methylphenylsulfonyloxy)diphenylmaleimide,
N-(4-methylphenylsulfonyloxy)bicyclo[2.2.1]hepto-5-ene-2,3-dicarboxylimide,
N-(4-methylphenylsulfonyloxy)-7-oxabicyclo[2.2.1]hepto-5-en e-2,3-dicarboxylimide,
N-(4-methylphenylsulfonyloxy)bicyclo[2.2.1]heptane-5,6-oxy-2,3-dicarboxylimide,
N-(4-methylphenylsulfonyloxy)naphthyldicarboxylimide,
N-(2-trifluoromethylphenylsulfonyloxy)succinimide,
N-(2-trifluoromethylphenylsulfonyloxy)phthalimide,
N-(2-trifluoromethylphenylsulfonyloxy)diphenylmaleimide,
N-(2-trifluoromethylphenylsulfonyloxy)bicyclo[2.2.1]hepto-5 -ene-2,3-dicarboxylimide,
N-(2-trifluoromethylphenylsulfonyloxy)-7-oxabicyclo[2.2.1]h epto-5-ene-2,3-dicarboxylimide,
N-(2-trifluoromethylphenylsulfonyloxy)bicyclo[2.2.1]heptane -5,6-oxy-2,3-dicarboxylimide,
N-(2-trifluoromethylphenylsulfonyloxy)naphthyldicarboxylimi de, N-(4-fluorophenylsulfonyloxy)succinimide,
N-(2-fluorophenylsulfonyloxy)phthalimide,
N-(4-fluorophenylsulfonyloxy)diphenylmaleimide,
N-(4-fluorophenylsulfonyloxy)bicyclo[2.2.1]hepto-5-ene-2,3-dicarboxylimide,
N-(4-fluorophenylsulfonyloxy)-7-oxabicyclo[2.2.1]hepto-5-en e-2,3-dicarboxylimide,
N-(4-fluorophenylsulfonyloxy)bicyclo[2.2.1]heptane-5,6-oxy-2,3-dicarboxylimide, and
N-(4-fluorophenylsulfonyloxy)naphthyldicarboxylimide.

Examples of (f) the photo acid generating agent other than the above compounds include 5-norbornene-2,3-dicarboxyimidyl triflate (trade name "NDI-105" produced by Midori Kagaku Co., Ltd.), 5-norbornene-2,3-dicarboxyimidyl tosylate (trade name "NDI-101" produced by Midori Kagaku Co., Ltd.), 4-methylphenylsulfonyloxyimino-$\alpha$-(4-methoxyphenyl)acetonitr ile (trade name "PAI-101" produced by Midori Kagaku Co. , Ltd.), trifluoromethylsulfonyloxyimino-$\alpha$-(4-methoxyphenyl)acetonit rile (trade name "PAI-105" produced by Midori Kagaku Co. , Ltd.), 9-camphorsulfonyloxyimino $\alpha$-4-methoxyphenylacetonitrile (trade name "PAI-106" produced by Midori Kagaku Co., Ltd.), 1,8-naphthalimidyl butanesulfonate (trade name "NAI-1004" produced by Midori Kagaku Co., Ltd.), 1,8-naphthalimidyl tosylate (trade name "NAI-101" produced by Midori Kagaku Co., Ltd.), 1,8-naphthalimidyl triflate (trade name "NAI-105" produced by Midori Kagaku Co., Ltd.), 1,8-naphthalimidyl nonafluorobutanesulfonate (trade name "NAI-109" produced by Midori Kagaku Co., Ltd.), and the like. Among these, particularly preferred compounds are TPS-105, WPAG-339, WPAG-370, TPS-109, diphenyliodonium pyrenesulfonate, NDI-105, PAI-101, and NAI-105.

Furthermore, (f) the photo acid generating agent is preferably used in combination with (g) a sensitizer. Since the sensitizer does not cause coloring due to a photobleaching reaction, it can achieve high sensitivity while maintaining high transparency even if it exists in the gate insulating film. The sensitizer is not particularly limited and a publicly known material can be used; however, a 9,10-disubstituted anthracene-based compound is particularly preferred as a sensitizer.

Examples of the 9,10-disubstituted anthracene-based compound include 9,10-diphenylanthracene, 9,10-bis(4-methoxyphenyl)anthracene, 9,10-bis(triphenylsilyl)anthracene, 9,10-dimethoxyanthracene, 9,10-diethoxyanthracene, 9,10-dipropoxyanthracene, 9,10-dibutoxyanthracene, 9,10-dipentaoxyanthracene, 2-t-butyl-9,10-dibutoxyanthracene and 9,10-bis(trimethylsilylethynyl)anthracene. Among these, particularly preferred compounds are 9,10-dimethoxyanthracene, 9,10-diethoxyanthracene, 9,10-dipropoxyanthracene, and 9,10-dibutoxyanthracene.

The composition of the present invention may contain a viscosity modifier, a surfactant, and a stabilizer, as required.

Examples of the surfactant include fluorine-based surfactants, silicone-based surfactants, polyalkylene oxide-based surfactants, acrylic surfactants, and the like.

Specific Examples of the fluorine-based surfactants include 1,1,2,2-tetrafluorooctyl(1,1,2,2-tetrafluoropropyl)ether, 1,1,2,2-tetrafluorooctylhexyl ether, octaethylene glycol di(1,1,2,2-tetrafluorobutyl)ether, hexaethylene glycol (1,1,2,2,3,3-hexafluoropentyl)ether, octapropylene glycol di(1,1,2,2-tetrafluorobutyl)ether, hexapropylene glycol di(1,1,2,2,3,3-hexafluoropentyl)ether, sodium perfluorododecylsulfonate, 1,1,2,2,8,8,9,9,10,10-decafluorododecane, 1,1,2,2,3,3-hexafluorodecane, N-[3-(perfluorooctanesulfonamide)propyl]-N,N'-dimethyl-N-ca rboxymethylene ammonium betaine, perfluoroalkylsulfonamide propyltrimethylammonium salt, perfluoroalkyl-N-ethylsulfonylglycine salt, bis(N-perfluorooctylsulfonyl-N-ethylaminoethyl) phosphate and monoperfluoroalkyl ethylphosphoric acid ester. Further, commercially available fluorine-based surfactants include Megafac F142D, Megafac F172, Megafac F173, Megafac F183 (respectively produced by Dainippon Ink and Chemicals, Inc.), Eftop EF301, Eftop EF303, Eftop EF352 (respectively produced by Shin-Akita Kasei K.K.), Fluorad FC-430, Fluorad FC-431 (respectively produced by Sumitomo 3M Ltd.), Asahi Guard AG710, Surflon S-382, Surflon SC-101, Surflon SC-102, Surflon SC-103, Surflon SC-104, Surflon SC-105, Surflon SC-106 (respectively produced by Asahi Glass Co., Ltd.), BM-1000, BM-1100 (respectively produced by Yusho Co., Ltd.), NBX-15, FTX-218 (respectively produced by NEOS Co., Ltd.), and the like.

Examples of the silicone-based surfactant include SH 28 PA, SH 7 PA, SH 21 PA, SH 30 PA, ST 94 PA (every produced by Toray Dow Corning Silicone Co., Ltd.), and BYK-333 (produced by BYK Japan KK). Examples of other surfactants include polyoxyethylene lauryl ether, polyoxyethylene stearyl ether, polyoxyethylene nonylphenyl ether, and polyoxyethylene distearate.

The composition of the present invention can also be widely used as a material for forming an insulating film since an insulating property, a film forming property and chemical resistance of the film obtained by using the composition are high. Particularly, when the composition is used as a material for a gate insulating film in an FET, the voltage of the threshold value and the leak current of the FET can be reduced to exert preferred FET characteristics. The insulating film referred to in the present invention refers to a film having volume resistivity of $10^8 \Omega\cdot cm$ or more, in which the volume resistivity is a measure of difficulty of conduction of electricity

<Method for Manufacturing Field Effect Transistor>

A method for manufacturing the FET shown in Fig. 1 will be described. The method for manufacturing the FET includes the step of applying the composition onto a substrate and drying the composition to form a gate insulating layer. In addition, the manufacturing method is not limited to the following method.

At first, a gate electrode 2 is formed on a substrate 1. Examples of a method of forming the gate electrode 2 include publicly known methods such as a metal vapor deposition method, a spin coating method, a blade coating method, a slit die coating method, a screen printing method, a bar coating method, a casting method, a transfer printing method, an immersion and withdrawal method, and an ink-jet method. In addition, a pattern may be formed directly with use of a mask or the like, or the gate electrode may be patterned by applying a resist onto the formed gate electrode, exposing/developing the resist film into a desired pattern, and etching the developed resist film.

Next, a gate insulating layer 3 is formed on the substrate. An insulating film can be formed by heat-treating, as required, a coating film obtained by applying the composition onto a glass substrate or a plastic substrate and drying the composition. Examples of a method of forming the gate insulating layer 3 include publicly known methods such as a spin coating method, a blade coating method, a slit die coating method, a screen printing method, a bar coating method, a casting method, a transfer printing method, an immersion and withdrawal method, and an ink-jet method. The temperature of the heat treatment of the coating film is preferably in the range of 100 to 300°C. The temperature is more preferably 200°C or less from the viewpoint of formation of the insulating film on the plastic substrate. Further, when the composition contains (f) a photo acid generating agent, the insulating film can be formed by heat-treating the coating film after exposure and development of the coating film. The drying temperature is preferably 50 to 150°C.

The gate insulating layer 3 is composed of a monolayer or plural layers. In the case of the plural layers, the insulating film of the present invention may be plural layers which are laminated, or the insulating film of the present invention and a publicly known insulating film may be laminated. The publicly known insulating film is not particularly limited, and inorganic materials such as silicon oxide and alumina; polymer materials such as polyimide, polyvinyl alcohol, polyvinyl chloride, polyethylene terephthalate, poly(vinylidene fluoride), polysiloxane and polyvinylphenol (PVP); or a mixture of an inorganic material powder and the polymer material can be used.

In the process of preparing the gate insulating layer in the manner described above, the coating film or the insulating film can be patterned. As an example, pattern formation of the coating film performed by using the composition containing (f) a photo acid generating agent will be described. Chemical rays are irradiated (exposure to light) through

a mask having a desired pattern from above the coating film. Examples of the chemical rays used for exposure include ultraviolet light, visible light, electron beam and X-ray, but in the present invention, it is preferred to use an i-beam (365 nm), an h-beam (405 nm), and a g-beam (436 nm) of a mercury lamp. Next, the exposed coating film is developed. As a developer, an aqueous solution of a compound exhibiting alkalinity such as tetramethylammonium, diethanolamine, diethylaminoethanol, sodium hydroxide, potassium hydroxide, sodium carbonate, potassium carbonate, triethylamine, diethylamine, methylamine, dimethylamine, dimethylaminoethyl acetate, dimethylaminoethanol, dimethylaminoethyl methacrylate, cyclohexylamine, ethylenediamine, or hexamethylenediamine is preferred and the developer may contains one or two or more compounds exhibiting alkalinity. Further, it is also possible to mix, with these alkaline aqueous solution, a polar solvent such as N-methyl-2-pyrolidone, N,N-dimethylformamide, N,N-dimethylacetamide, dimethyl sulfoxide, γ-butyrolactone or dimethylacrylamide; alcohol such as methanol, ethanol or isopropanol; esters such as ethyl lactate, propylene glycol monomethyl ether acetate; or ketones such cyclopentanone, cyclohexanone, isobutyl ketone or methyl isobutyl ketone. After development, the coating film is generally rinsed with water; however, the coating film may be rinsed with water to which alcohols such as ethanol or isopropyl alcohol, or esters such as ethyl lactate or propylene glycol monomethyl ether acetate have been previously added.

Further, it is also possible to pattern the insulating film by applying a resist onto the insulating film, exposing/developing the resist film into a desired pattern, and then treating the developed resist film with an etchant such as hydrofluoric acid. According to this method, even a composition not containing a composition containing (f) a photo acid generating agent can be patterned.

Next, a source electrode and a drain electrode are formed. Examples of a method of forming a source electrode 5 and a drain electrode 6 include, as with the gate electrode 2, publicly known methods such as a metal vapor deposition method, a spin coating method, a blade coating method, a slit die coating method, a screen printing method, a bar coating method, a casting method, a transfer printing method, an immersion and withdrawal method, and an ink-jet method. In addition, a pattern may be formed directly with use of a mask or the like, or the source electrode and the drain electrode may be patterned by applying a resist onto the formed electrode, exposing/developing the resist film into a desired pattern, and etching the developed resist film.

Next, a semiconductor layer 4 is formed by the above-mentioned method of forming to produce an FET. Moreover, the step of forming an oriented layer between the gate insulating layer 3 and the semiconductor layer 4 and forming a second insulating layer on a side opposite to the gate insulating layer 3 with respect to the semiconductor layer 4 by the above method of forming, may be added.

The composition and the insulating film of the present invention can be advantageously used for manufacturing various devices such as a thin film field-effect transistor, a photovoltaic element and a switching element.

## EXAMPLES

Hereinafter, the present invention will be described by way of examples, but the present invention is not limited to these examples. Evaluation methods used in these examples will be described in the following paragraphs (1) to (3).

### (1) Measurement of Solid Concentration

A solution (1 g) aimed at being measured was weighed out in an aluminum cup and heated at 250°C for 30 minutes using a hot plate to evaporate a liquid fraction. The solid content remaining in the aluminum cup after heating was weighed to determine the solid concentration in the solution.

### (2) Measurement of Weight Average Molecular Weight

The weight average molecular weight of polysiloxane was determined on the polystyrene equivalent basis by using GPC (HLC-8220GPC manufactured by TOSOH CORPORATION) (eluent: tetrahydrofuran, flow rate: 0.4 ml/min) after filtering the sample with a membrane filter with pore size of 0.45 μm.

### (3) Elemental Analysis

Elemental information and an elemental amount in a film were analyzed by X-ray photoelectron spectroscopy (Quantera SXM manufactured by Physical Electronics, Inc. (PHI)) which detects photoelectrons emitted from the surface of the film by irradiating the film aimed at being measured with a soft X-ray in an ultrahigh vacuum.

[Example 1]

(1) Preparation of Semiconductor Solution

Poly (3-hexylthiophene) (produced by Aldrich Chemical Co., Inc., regioregular, number average molecular weight (Mn):13000, hereafter referred to as P3HT) (0.10 g) was added to 5 ml of chloroform in a flask and the resulting mixture was mixed by ultrasonic agitation in an ultrasonic cleaner (US-2 manufactured by Iuchi Seieido Co. , Ltd. , output 120 W) to obtain a chloroform solution of P3HT. Then, this solution was taken with a dropping syringe and added dropwise 0.5 ml-by-0.5 ml to a mixed solution of 20 ml of methanol and 10 ml of 0.1N hydrochloric acid to perform reprecipitation. The solidified P3HT was separated from the solution through filtration by a membrane filter (manufactured by PTFE Co.: ethylene tetrafluoride) with pore size of 0.1 μm and collected and adequately rinsed with methanol, and then a solvent was removed by vacuum-drying. Dissolving and reprecipitation were repeated once more to obtain 90 mg of reprecipitated P3HT.

Next, 1.5 mg of CNT (manufactured by CNI Inc., single-walled CNT, purity 95%) and 1.5 mg of the above P3HT were added to 15 ml of chloroform, and the resulting mixture was mixed by ultrasonic agitation using an ultrasonic homogenizer (VCX-500 manufactured by TOKYO RIKAKIKAI Co. , Ltd.) at an output of 250 W for 30 minutes while chilling in ice. Ultrasonic application was stopped once at the time when ultrasonic irradiation was carried out for 30 minutes, and 1.5 mg of the P3HT was further added and ultrasonic irradiation was further carried out for 1 minute to obtain a CNT dispersion A (a concentration of CNT composite with respect to the solvent was 0.1 g/l).

Next, a semiconductor solution for forming a semiconductor layer 4 was prepared. The CNT dispersion A was filtered using a membrane filter (pore size 10 μm, diameter 25 mm, Omnipore membrane filter manufactured by Millipore Corp.) to eliminate the CNT composites having a length of 10 μm or longer. Then, 45 ml of dichlorobenzene was added to 5 ml of the resulting filtrate to form a semiconductor solution A (a concentration of CNT composite with respect to the solvent was 0.01 g/l).

(2) Preparation of Composition (Insulating Material Solution)

Methyltrimethoxysilane (61.29 g (0.45 mole)), 2-(3,4-epoxycyclohexyl)ethyltrimethoxysilane (12.31 g (0.05 mole)), and phenyltrimethoxysilane (99.15 g (0.5 mole)) were dissolved in propylene glycol monobutyl ether (boiling point 170°C, 203.36 g), and to the resulting solution, water (54.90 g) and phosphoric acid (0.864 g) were added while stirring. The resulting solution was heated at a bath temperature of 105°C for 2 hours to raise an internal temperature to 90°C to distill off a component predominantly composed of methanol as a by-product. Subsequently, the solution was heated at a bath temperature of 130°C for 2 hours to raise an internal temperature to 118°C to distill off a component predominantly composed of water and propylene glycol monobutyl ether, and then the solution was cooled to room temperature to obtain a polysiloxane solution A having a solid concentration of 26.0 wt %. The weight average molecular weight of the obtained polysiloxane was 6,000.

The obtained polysiloxane solution A (10 g) was weighed out, and the solution, aluminum bis(ethyl acetoacetate)mono(2,4-pentanedionato) (trade name "Alumichelate D", produced by Kawaken Fine Chemicals Co. , Ltd. , hereinafter, referred to as Alumichelate D) (13g) and propylene glycol monoethyl ether acetate (hereinafter, referred to as PGMEA) (42 g) were mixed, and the resulting mixture was stirred at room temperature for 2 hours to obtain an insulating material solution A (solid concentration 24 wt %). The content of the polysiloxane in the solution was 20 parts by weight with respect to 100 parts by weight of Alumichelate D. The insulating material solution A was stored at room temperature for one month in the air, and consequently a precipitate of the solution was not observed and the solution was stable.

(3) Preparation of FET

An FET shown in Fig. 1 was prepared. Chrome and gold were vacuum-deposited on a glass substrate 1 (film thickness 0.7 mm) through a mask so as to have thicknesses of 5 nm and 50 nm, respectively, by resistance heating to form a gate electrode 2. Next, the insulating material solution A prepared by the method described in the above paragraph (2) was applied by spin coating (800 rpm × 20 seconds) onto the glass substrate on which the above-mentioned gate electrode had been formed, and heat-treated at 120°C for 5 minutes, and then the insulating material solution A was applied by spin coating (800 rpm × 20 seconds) again and heat-treated at 200°C for 30 minutes in a nitrogen stream to form a gate insulating layer 3 having a film thickness of 400 nm. Then, gold was vacuum-deposited so as to have a thickness of 50 nm by resistance heating, and thereon, a photoresist (trade name "LC100-10cP", manufactured by Rohm and Haas Company) was applied by spin coating (1000 rpm × 20 seconds) and heated/dried at 100°C for 10. After the prepared photoresist was pattern-exposed through a mask using a parallel light mask aligner (PLA-501F manufactured by Canon Inc.), the exposed film was shower-developed with ELM-D (trade name, manufactured by MITSUBISHI GAS CHEMICAL CO., INC.), 2.38% by weight aqueous solution of tetramethylammonium hydroxide, for 70 seconds using

an automatic developing apparatus (AD-2000 manufactured by Takizawa Sangyo Co. , Ltd.), and then rinsed with water for 30 seconds. Thereafter, the film pattern-exposed was etched for 5 minutes with AURUM-302 (trade name, produced by KANTO CHEMICAL CO., INC.), and then rinsed with water for 30 seconds. The gate insulating layer 3 with the gold/chrome films and the resist film was immersed in AZ 100 Remover (trade name, produced by AZ Electronic Materials Corp.) for 5 minutes to peel the resist, rinsed with water for 30 seconds, and then heated /dried at 120°C for 20 minutes to form a source electrode 5 and a drain electrode 6.

A width (channel width) of each of these both electrodes was set at 100 μm, a distance (channel length) between both electrodes was set at 10 μm. The semiconductor solution A prepared by the method described in the above (1) was added dropwise by 400 pl to the surface of the substrate provided with the electrodes by using an ink-jet apparatus (manufactured by Cluster Technology Co., Ltd.) and the semiconductor solution A was heat-treated at 150°C for 30 minutes on a hot plate in a nitrogen flow to form a semiconductor layer 4. An FET was obtained.

Next, characteristics of current (Id) between source and drain-voltage (Vsd) between source and drain at the time of changing a gate voltage (Vg) of the above FET were measured. The measurement was carried out in the atmosphere (atmospheric temperature 20°C, humidity 35%) using Semiconductor Characterization System MODEL 4200-SCS (manufactured by Keithley Instruments Inc.). The mobility in a linear region was determined from changes in Id value at Vsd of -5 V at the time of changing Vg between +20 V and -20 V to yield 0.42 $cm^2/V \cdot sec$. Further, the voltage of the threshold value was determined from a point of intersection of an extension line of a linear portion and a Vg axial in an Id-Vg graph, and consequently the voltage of the threshold value was 0.5 V, and the leak current value at Vg of -20 V was 6.9 pA. Moreover, the gate insulating layer at this time was analyzed by X-ray photoelectron spectroscopy, and consequently the amount of aluminum atoms was 21.0 parts by weight with respect to 100 parts by weight of the total of carbon atoms and silicon atoms.

[Comparative Example 1]

An insulating material solution B was prepared in the same manner as in (2) in Example 1 except for changing the amounts of the Alumichelate D and the PGMEA to 2.6 g and 52.4 g, respectively. The content of the polysiloxane in the solution was 100 parts by weight with respect to 100 parts by weight of the Alumichelate D. Next, an FET was prepared in the same manner as in Example 1 except for forming a gate insulating layer with use of the insulating material solution B, and characteristics of the FET were measured. The insulating material solution B was stored at room temperature for one month in the air, and consequently a precipitate of the solution was not observed and the solution was stable. The mobility in a linear region was determined from changes in Id value at Vsd of -5 V at the time of changing Vg between +20 V and -20 V to yield 0.38 $cm^2/V \cdot sec$. Further, the voltage of the threshold value was determined from a point of intersection of an extension line of a linear portion and a Vg axial in an Id-Vg graph, and consequently the voltage of the threshold value was 0.5 V, but the leak current value at Vg of -20 V was as large as 56.5 pA. The gate insulating layer at this time was analyzed by X-ray photoelectron spectroscopy, and consequently the amount of aluminum atoms was as small as 9.5 parts by weight with respect to 100 parts by weight of the total of carbon atoms and silicon atoms.

[Comparative Example 2]

An insulating material solution C was prepared in the same manner as in (2) in Example 1 except for changing the amounts of the Alumichelate D and the PGMEA to 1.3 g and 53.7 g, respectively. The content of the polysiloxane in the solution was 200 parts by weight with respect to 100 parts by weight of Alumichelate D. Next, an FET was prepared in the same manner as in Example 1 except for forming a gate insulating layer with use of the insulating material solution C, and characteristics of the FET were measured. The insulating material solution C was stored at room temperature for one month in the air, and consequently a precipitate of the solution was not observed and the solution was stable. The mobility in a linear region was determined from changes in Id value at Vsd of -5 V at the time of changing Vg between +20 V and -20 V to yield 0.39 $cm^2/V \cdot sec$. Further, the voltage of the threshold value was determined from a point of intersection of an extension line of a linear portion and a Vg axial in an Id-Vg graph, and consequently the voltage of the threshold value was 1.2 V, but the leak current value at Vg of -20 V was as large as 43.1 pA. The gate insulating layer at this time was analyzed by X-ray photoelectron spectroscopy, and consequently the amount of aluminum atoms was as small as 7.5 parts by weight with respect to 100 parts by weight of the total of carbon atoms and silicon atoms.

[Comparative Example 3]

An insulating material solution D was prepared in the same manner as in (2) in Example 1 except for changing the amounts of the Alumichelate D and the PGMEA to 0.13 g and 54.4 g, respectively. The content of the polysiloxane in the solution was 2000 parts by weight with respect to 100 parts by weight of Alumichelate D. Next, an FET was prepared in the same manner as in Example 1 except for forming a gate insulating layer with use of the insulating material

solution D, and characteristics of the FET were measured. The insulating material solution D was stored at room temperature for one month in the air, and consequently a precipitate of the solution was not observed and the solution was stable. The mobility in a linear region was determined from changes in Id value at Vsd of -5 V at the time of changing Vg between +20 V and -20 V to yield 0.27 $cm^2/V \cdot sec$. Further, the voltage of the threshold value was determined from a point of intersection of an extension line of a linear portion and a Vg axial in an Id-Vg graph, and consequently the voltage of the threshold value was as large as 10.5 V. The leak current value at Vg of -20 V was 9.1 pA. The gate insulating layer at this time was analyzed by X-ray photoelectron spectroscopy, and consequently the amount of aluminum atoms was as small as 2.5 parts by weight with respect to 100 parts by weight of the total of carbon atoms and silicon atoms.

[Comparative Example 4]

An insulating material solution E was prepared in the same manner as in (2) in Example 1 except for not using the polysiloxane solution A. Next, a gate insulating layer was formed with use of the insulating material solution E, but a uniform film was not obtained, and a prepared FET caused a short circuit.

[Comparative Example 5]

An insulating material solution F was prepared in the same manner as in (2) in Example 1 except for using Ethyl Silicate 40 (trade name, produced by COLCOAT CO., LTD., weight average molecular weight 800) in place of the polysiloxane solution A. Next, a gate insulating layer was formed with use of the insulating material solution F, but a uniform film was not obtained, and a prepared FET caused a short circuit.

[Example 2]

An insulating material solution G was prepared in the same manner as in (2) in Example 1 except for changing the amounts of the polysiloxane solution A, the Alumichelate D and the PGMEA to 5 g, 13 g and 47 g, respectively. The content of the polysiloxane in the solution was 10 parts by weight with respect to 100 parts by weight of Alumichelate D. The insulating material solution G was stored at room temperature for one month in the air, and consequently a precipitate of the solution was not observed and the solution was stable. Next, an FET was prepared in the same manner as in Example 1 except for forming a gate insulating layer by performing spin coating three times with use of the insulating material solution G, and the content of the aluminum atom with respect to 100 parts by weight of the total of carbon atoms and silicon atoms in the gate insulating layer and characteristics of the FET were measured.

[Example 3]

An insulating material solution F was prepared in the same manner as in (2) in Example 1 except for changing the amounts of the Alumichelate D and the PGMEA to 8.7 g and 46.3 g, respectively. The content of the polysiloxane in the solution was 30 parts by weight with respect to 100 parts by weight of Alumichelate D. The insulating material solution H was stored at room temperature for one month in the air, and consequently a precipitate of the solution was not observed and the solution was stable. Next, an FET was prepared in the same manner as in Example 1 except for forming a gate insulating layer with use of the insulating material solution H, and the content of the aluminum atom with respect to 100 parts by weight of the total of carbon atoms and silicon atoms in the gate insulating layer and characteristics of the FET were measured.

[Example 4]

An insulating material solution I was prepared in the same manner as in (2) in Example 1 except for changing the amounts of the Alumichelate D and the PGMEA to 5.2 g and 49.8 g, respectively. The content of the polysiloxane in the solution was 50 parts by weight with respect to 100 parts by weight of Alumichelate D. The insulating material solution I was stored at room temperature for one month in the air, and consequently a precipitate of the solution was not observed and the solution was stable. Next, an FET was prepared in the same manner as in Example 1 except for forming a gate insulating layer with use of the insulating material solution I, and the content of the aluminum atom with respect to 100 parts by weight of the total of carbon atoms and silicon atoms in the gate insulating layer and characteristics of the FET were measured.

[Example 5]

An insulating material solution J was prepared in the same manner as in (2) in Example 1 except for changing

the amounts of the polysiloxane solution A, the Alumichelate D and the PGMEA to 2.5 g, 13 g and 49.5 g, respectively. The content of the polysiloxane in the solution was 5 parts by weight with respect to 100 parts by weight of Alumichelate D. The insulating material solution J was stored at room temperature for one month in the air, and consequently a precipitate of the solution was not observed and the solution was stable. Next, an FET was prepared in the same manner as in Example 1 except for forming a gate insulating layer by performing spin coating four times with use of the insulating material solution J, and the content of the aluminum atom with respect to 100 parts by weight of the total of carbon atoms and silicon atoms in the gate insulating layer and characteristics of the FET were measured.

[Example 6]

An insulating material solution K was prepared in the same manner as in Example 4 except for using aluminum tris(ethylacetoacetate) (trade name "ALCH-TR", produced by Kawaken Fine Chemicals Co., Ltd.) in place of the Alumichelate D. The insulating material solution K was stored at room temperature for one month in the air, and consequently a precipitate of the solution was not observed and the solution was stable. Next, an FET was prepared in the same manner as in Example 1 except for forming a gate insulating layer with use of the insulating material solution K, and the content of the aluminum atom with respect to 100 parts by weight of the total of carbon atoms and silicon atoms in the gate insulating layer and characteristics of the FET were measured.

[Example 7]

An insulating material solution L was prepared in the same manner as in Example 4 except for using aluminum tris(2,4-pentanedionato) (trade name "Alumichelate A(W)", produced by Kawaken Fine Chemicals Co., Ltd.) in place of the Alumichelate D. The insulating material solution L was stored at room temperature for one month in the air, and consequently a precipitate of the solution was not observed and the solution was stable. Next, an FET was prepared in the same manner as in Example 1 except for forming a gate insulating layer with use of the insulating material solution L, and the content of the aluminum atom with respect to 100 parts by weight of the total of carbon atoms and silicon atoms in the gate insulating layer and characteristics of the FET were measured.

[Example 8]

An insulating material solution M was prepared in the same manner as in Example 4 except for using titanium tetra(2,4-pentanedionato) (trade name "Orgatics TC-401", produced by Matsumoto Fine Chemical Co. , Ltd.) in place of the Alumichelate D. The insulating material solution M was stored at room temperature for one month in the air, and consequently a precipitate of the solution was not observed and the solution was stable. Next, an FET was prepared in the same manner as in Example 1 except for forming a gate insulating layer with use of the insulating material solution M, and the content of the titanium atom with respect to 100 parts by weight of the total of carbon atoms and silicon atoms in the gate insulating layer and characteristics of the FET were measured.

[Example 9]

An insulating material solution N was prepared in the same manner as in Example 4 except for using zirconium tetra(2,4-pentanedionato) (trade name "Orgatics ZC-150", produced by Matsumoto Fine Chemicals Co. , Ltd.) in place of the Alumichelate D. The insulating material solution N was stored at room temperature for one month in the air, and consequently a precipitate of the solution was not observed and the solution was stable. Next, an FET was prepared in the same manner as in Example 1 except for forming a gate insulating layer with use of the insulating material solution N, and the content of the zirconium atom with respect to 100 parts by weight of the total of carbon atoms and silicon atoms in the gate insulating layer and characteristics of the FET were measured.

[Example 10]

An insulating material solution O was prepared in the same manner as in Example 4 except for using indium tris(2,4-pentanedionato) (produced by Wako Pure Chemical Industries, Ltd.) in place of the Alumichelate D. The insulating material solution O was stored at room temperature for one month in the air, and consequently a precipitate of the solution was not observed and the solution was stable. Next, an FET was prepared in the same manner as in Example 1 except for forming a gate insulating layer with use of the insulating material solution O, and the content of the indium atom with respect to 100 parts by weight of the total of carbon atoms and silicon atoms in the gate insulating layer and characteristics of the FET were measured.

[Example 11]

The following SPCR-69X (trade name, produced by Showa Denko K.K., weight average molecular weight 15000) (2.6 g) as the polymer, Alumichelate D (13 g) and PGMEA (49.4 g) were mixed, and the resulting mixture was stirred at room temperature for 2 hours to obtain an insulating material solution P (solid concentration 24 wt %). The content of SPCR-69X in the solution was 20 parts by weight with respect to 100 parts by weight of Alumichelate D. The insulating material solution P was stored at room temperature for one month in the air, and consequently a precipitate of the solution was not observed and the solution was stable. Next, an FET was prepared in the same manner as in Example 1 except for forming a gate insulating layer with use of the insulating material solution P, and the content of the aluminum atom with respect to 100 parts by weight of the total of carbon atoms and silicon atoms in the gate insulating layer and characteristics of the FET were measured.

[Chemical Formula 1]

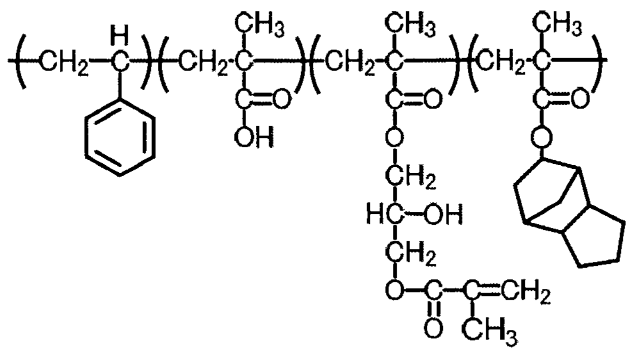

(SPCR−69X)

[Example 12]

A polysiloxane solution B was synthesized in the same manner as in (2) in Example 1 except for using 3-acryloxypropyl trimethoxysilane in place of 2-(3,4-epoxycyclohexyl)ethyltrimethoxysilane. The weight average molecular weight of the obtained polysiloxane was 5,000. The obtained polysiloxane solution B (10 g) was weighed out, and the solution, the Alumichelate D (13 g), and PGMEA (42 g) were mixed, and the resulting mixture was stirred at room temperature for 2 hours to obtain an insulating material solution Q (solid concentration 24 wt %). The content of the polysiloxane in the solution was 20 parts by weight with respect to 100 parts by weight of Alumichelate D. The insulating material solution Q was stored at room temperature for one month in the air, and consequently a precipitate of the solution was not observed and the solution was stable. Since siloxane not having an epoxy group was used for the insulating material solution Q, a part of a resist was peeled off when a resist was applied onto an insulating film formed by using the insulating material solution Q and the resist was developed. Next, an FET was prepared in the same manner as in Example 1 except for forming a gate insulating layer with use of the insulating material solution Q, and the content of the aluminum atom with respect to 100 parts by weight of the total of carbon atoms and silicon atoms in the gate insulating layer and characteristics of the FET were measured.

[Example 13]

The polysiloxane solution A (4 g), the Alumichelate D (13 g), PGMEA (47 g), and M Silicate 51 (trade name, produced by TAMA CHEMICALS CO., LTD.) (1 g) as a (d) component were mixed, and the resulting mixture was stirred at room temperature for 2 hours to obtain an insulating material solution R (solid concentration 24 wt %). The content of the polysiloxane in the solution was 20 parts by weight with respect to 100 parts by weight of Alumichelate D. The insulating material solution R was stored at room temperature for one month in the air, and consequently a precipitate of the solution was not observed and the solution was stable. Next, an FET was prepared in the same manner as in Example 1 except for forming a gate insulating layer by performing a heating treatment at 150°C for 30 minutes under a nitrogen flow with use of the insulating material solution R, and the content of the aluminum atom with respect to 100 parts by weight of the total of carbon atoms and silicon atoms in the gate insulating layer and characteristics of the FET were measured.

[Example 14]

An insulating material solution S was prepared in the same manner as in Example 3 except for using ALCH-TR in place of the Alumichelate D. The insulating material solution S was stored at room temperature for one month in the air, and consequently a precipitate of the solution was not observed and the solution was stable. Next, an FET was prepared in the same manner as in Example 1 except for forming a gate insulating layer with use of the insulating material solution S, and the content of the aluminum atom with respect to 100 parts by weight of the total of carbon atoms and silicon atoms in the gate insulating layer and characteristics of the FET were measured.

[Example 15]

An insulating material solution T was prepared in the same manner as in Example 3 except for using Alumichelate A(W) in place of the Alumichelate D. The insulating material solution T was stored at room temperature for one week in the air, and consequently the solution was solidified in the form of gel. Next, an FET was prepared in the same manner as in Example 1 except for forming a gate insulating layer with use of the insulating material solution L, and the content of the aluminum atom with respect to 100 parts by weight of the total of carbon atoms and silicon atoms in the gate insulating layer and characteristics of the FET were measured.

[Chemical Formula 2]

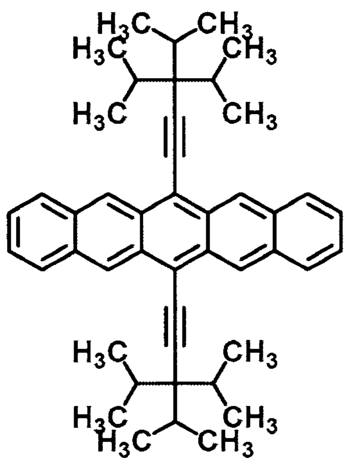

(OSC)

[Example 16]

A semiconductor solution C was prepared in the same manner as in Example 1 (1) except for using the CNT in which a purity of a highly semiconductor enriched CNT (manufactured by KH Chemicals Co. , Ltd., single-walled CNT, purity 90%) was changed to 95%. Next, an FET was prepared in the same manner as in Example 1 except for forming a semiconductor layer with use of the semiconductor solution C, and the content of the aluminum atom with respect to 100 parts by weight of the total of carbon atoms and silicon atoms in the gate insulating layer and characteristics of the FET were measured.

The evaluation results of FETs of Examples 1 to 16 and Comparative Examples 1 to 3 are shown in Table 1. The composition of the insulating material solutions of Examples 1 to 16 and Comparative Examples 1 to 5 is shown in Table 2.

[Table 1]

| | Semiconductor layer | Gate insulating layer | | Characteristics of FET | | | Storage Stability at Room Temperature during 1 Month |
|---|---|---|---|---|---|---|---|
| | | Composition | Weight of Metal Atoms with respect to 100 Parts by Weight of Carbon Atoms and Silicon Atoms | Mobility ($cm^2/Vs$) | Voltage of Threshold Value (V) | Leak Current (pA) | |
| Example 1 | Semiconductor solution A | Insulating material solution A | 21.0 | 0.42 | 0.5 | 6.9 | No deposit |
| Example 2 | Semiconductor solution A | Insulating material solution G | 30.0 | 0.45 | 0.2 | 7.5 | No deposit |
| Example 3 | Semiconductor solution A | Insulating material solution H | 18.0 | 0.40 | 0.8 | 6.5 | No deposit |
| Example 4 | Semiconductor solution A | Insulating material solution I | 14.0 | 0.38 | 2.1 | 10.2 | No deposit |
| Example 5 | Semiconductor solution A | Insulating material solution J | 41.0 | 0.43 | 0.2 | 11.4 | No deposit |
| Example 6 | Semiconductor solution A | Insulating material solution K | 14.8 | 0.43 | 2.0 | 10.8 | No deposit |
| Example 7 | Semiconductor solution A | Insulating material solution L | 12.4 | 0.44 | 2.3 | 10.6 | No deposit |
| Example 8 | Semiconductor solution A | Insulating material solution M | 22.0 | 0.40 | 2.5 | 15.4 | No deposit |
| Example 9 | Semiconductor solution A | Insulating material solution N | 41.6 | 0.39 | 3.4 | 9.8 | No deposit |
| Example 10 | Semiconductor solution A | Insulating material solution O | 52.6 | 0.41 | 3.0 | 12.1 | No deposit |
| Example 11 | Semiconductor solution A | Insulating material solution P | 21.0 | 0.38 | 1.4 | 9.1 | No deposit |

(continued)

| | Semiconductor layer | Gate insulating layer | | Characteristics of FET | | | Storage Stability at Room Temperature during 1 Month |
|---|---|---|---|---|---|---|---|
| | | Composition | Weight of Metal Atoms with respect to 100 Parts by Weight of Carbon Atoms and Silicon Atoms | Mobility ($cm^2/Vs$) | Voltage of Threshold Value (V) | Leak Current (pA) | |
| Example 12 | Semiconductor solution A | Insulating material solution Q | 21.0 | 0.40 | 1.3 | 7.3 | No deposit |
| Example 13 | Semiconductor solution A | Insulating material solution R | 21.0 | 0.43 | 0.4 | 6.7 | No deposit |
| Example 14 | Semiconductor solution A | Insulating material solution S | 19.1 | 0.41 | 0.8 | 6.6 | No deposit |
| Example 15 | Semiconductor solution A | Insulating material solution T | 15.9 | 0.40 | 0.9 | 6.8 | Solidified in the form of gel |
| Example 16 | Semiconductor solution C | Insulating material solution A | 21.0 | 0.80 | 0.5 | 6.8 | No deposit |
| Comparative Example 1 | Semiconductor solution A | Insulating material solution B | 9.5 | 0.38 | 0.5 | 56.5 | No deposit |
| Comparative Example 2 | Semiconductor solution A | Insulating material solution C | 7.5 | 0.39 | 1.2 | 43.1 | No deposit |
| Comparative Example 3 | Semiconductor solution A | Insulating material solution D | 2.5 | 0.27 | 10.5 | 9.1 | No deposit |

[Table 2]

| | Composition | (a) Metal Chelate | | (b) Polymer | Weight Average Molecular Weight of (b) Polymer | Weight of (b) with respect to 100 Parts by Weight of (a) | (c) Solvent | Other Additives |
|---|---|---|---|---|---|---|---|---|
| | | Metal | Ligand | | | | | |
| Example 1 | Insulating material solution A | Aluminum | bis(ethyl acetoacetate) mono(2,4-pentanedionato) | Polysiloxane solution A | 6000 | 20 | PGMEA | - |
| Example 2 | Insulating material solution G | Aluminum | bis(ethyl acetoacetate) mono(2,4-pentanedionato) | Polysiloxane solution A | 6000 | 10 | PGMEA | - |
| Example 3 | Insulating material solution H | Aluminum | bis(ethyl acetoacetate) mono(2,4-pentanedionato) | Polysiloxane solution A | 6000 | 30 | PGMEA | - |
| Example 4 | Insulating material solution I | Aluminum | bis(ethyl acetoacetate) mono(2,4-pentanedionato) | Polysiloxane solution A | 6000 | 50 | PGMEA | - |
| Example 5 | Insulating material solution J | Aluminum | bis(ethyl acetoacetate) mono(2,4-pentanedionato) | Polysiloxane solution A | 6000 | 5 | PGMEA | - |
| Example 6 | Insulating material solution K | Aluminum | tris(ethyl acetoacetate) | Polysiloxane solution A | 6000 | 50 | PGMEA | - |
| Example 7 | Insulating material solution L | Aluminum | tris(2,4-pentanedionato) | Polysiloxane solution A | 6000 | 50 | PGMEA | - |
| Example 8 | Insulating material solution M | Titanium | tris(2,4-pentanedionato) | Polysiloxane solution A | 6000 | 50 | PGMEA | - |
| Example 9 | Insulating material solution N | Zirconium | tris(2,4-pentanedionato) | Polysiloxane solution A | 6000 | 50 | PGMEA | - |
| Example 10 | Insulating material solution O | Indium | tris(2,4-pentanedionato) | Polysiloxane solution A | 6000 | 50 | PGMEA | - |

(continued)

| | Composition | (a) Metal Chelate | | (b) Polymer | Weight Average Molecular Weight of (b) Polymer | Weight of (b) with respect to 100 Parts by Weight of (a) | (c) Solvent | Other Additives |
|---|---|---|---|---|---|---|---|---|
| | | Metal | Ligand | | | | | |
| Example 11 | Insulating material solution P | Aluminum | bis(ethyl acetoacetate) mono(2,4-pentanedionato) | SPCR-69X | 15000 | 20 | PGMEA | - |
| Example 12 | Insulating material solution Q | Aluminum | bis(ethyl acetoacetate) mono(2,4-pentanedionato) | Polysiloxane solution B | 5000 | 20 | PGMEA | - |
| Example 13 | Insulating material solution R | Aluminum | bis(ethyl acetoacetate) mono(2,4-pentanedionato) | Polysiloxane solution A | 6000 | 20 | PGMEA | M Silicate 51 |
| Example 14 | Insulating material solution S | Aluminum | tris(ethyl acetoacetate) | Polysiloxane solution A | 6000 | 30 | PGMEA | - |
| Example 15 | Insulating material solution T | Aluminum | tris(2,4-pentanedionato) | Polysiloxane solution A | 6000 | 30 | PGMEA | - |
| Example 16 | Insulating material solution A | Aluminum | bis(ethyl acetoacetate) mono(2,4-pentanedionato) | Polysiloxane solution A | 6000 | 20 | PGMEA | - |
| Comparative Example 1 | Insulating material solution B | Aluminum | bis(ethyl acetoacetate) mono(2,4-pentanedionato) | Polysiloxane solution A | 6000 | 100 | PGMEA | - |
| Comparative Example 2 | Insulating material solution C | Aluminum | bis(ethyl acetoacetate) mono(2,4-pentanedionato) | Polysiloxane solution A | 6000 | 200 | PGMEA | - |
| Comparative Example 3 | Insulating material solution D | Aluminum | bis(ethyl acetoacetate) mono(2,4-pentanedionato) | Polysiloxane solution A | 6000 | 2000 | PGMEA | - |
| Comparative Example 4 | Insulating material solution E | Aluminum | bis(ethyl acetoacetate) mono(2,4-pentanedionato) | - | - | 20 | PGMEA | - |

(continued)

| | Composition | (a) Metal Chelate | | (b) Polymer | Weight Average Molecular Weight of (b) Polymer | Weight of (b) with respect to 100 Parts by Weight of (a) | (c) Solvent | Other Additives |
|---|---|---|---|---|---|---|---|---|
| | | Metal | Ligand | | | | | |
| Comparative Example 5 | Insulating material solution F | Aluminum | bis(ethyl acetoacetate) mono(2,4-pentanedionato) | Ethyl Silicate 40 | 800 | 20 | PGMEA | - |

[Reference Signs List]

1 Substrate
2 Gate electrode
3 Gate insulating layer
4 Semiconductor layer
5 Source electrode
6 Drain electrode

## Claims

1. A field effect transistor comprising a gate insulating layer, a gate electrode, a semiconductor layer, a source electrode and a drain electrode, wherein the gate insulating layer contains an organic compound containing a silicon-carbon bond and a metal compound containing a bond between a metal atom and an oxygen atom; and the metal atoms are contained in the gate insulating layer in an amount of 10 to 180 parts by weight with respect to 100 parts by weight of the total of carbon atoms and silicon atoms.

2. The field effect transistor according to claim 1, wherein the metal atoms are contained in the gate insulating layer in an amount of 17 to 30 parts by weight with respect to 100 parts by weight of the total of carbon atoms and silicon atoms.

3. The field effect transistor according to claim 1 or 2, wherein the metal atom is aluminum.

4. The field effect transistor according to any one of claims 1 to 3, wherein a film thickness of the gate insulating layer is 0.05 $\mu$m to 5 $\mu$m.

5. The field effect transistor according to any one of claims 1 to 4, wherein the semiconductor layer contains a single-walled carbon nanotube.

6. The field effect transistor according to claim 5, wherein the single-walled carbon nanotube contains a highly semiconductor enriched single-walled carbon nanotube in an amount of 90% by weight or more.

7. A composition comprising (a) a metal chelate represented by the general formula (1), (b) a polymer having a weight average molecular weight of 1000 or more, and (c) a solvent, (b) the polymer having a weight average molecular weight of 1000 or more being contained in an amount of 5 to 90 parts by weight with respect to 100 parts by weight of (a) the metal chelate represented by the general formula (1):

$$R^1_xM(OR^2)_{y-x} \qquad (1)$$

(wherein, $R^1$ represents a monovalent bidentate ligand and in the case of a plurality of $R^1$s, $R^1$s may be the same or different, $R^2$ represents hydrogen, an alkyl group, an acyl group or an aryl group and in the case of a plurality of $R^2$s, $R^2$s may be the same or different, M represents a y-valent metal atom, a value of y is 1 to 6, and x represents an integer of 1 to y)."

8. The composition according to claim 7, wherein (b) the polymer having a weight average molecular weight of 1000 or more is contained in an amount of 10 to 30 parts by weight with respect to 100 parts by weight of (a) the metal chelate represented by the general formula (1).

9. The composition according to claim 7 or 8, wherein (b) the polymer having a weight average molecular weight of 1000 or more is polysiloxane.

10. The composition according to claim 9, wherein the polysiloxane contains, as copolymerization components, at least a silane compound represented by the general formula (3) and an epoxy group-containing silane compound represented by the general formula (4):

$R^3_mSi(OR^4)_{4-m}$ (3)

(wherein $R^3$ represents hydrogen, an alkyl group, a heterocyclic group, an aryl group or an alkenyl group and in the case of a plurality of $R^3$s, $R^3$s may be the same or different, $R^4$ represents hydrogen, an alkyl group, an acyl group or an aryl group and in the case of a plurality of $R^4$s, $R^4$s may be the same or different, and m represents an integer of 1 to 3); and

$R^5_nR^6_lSi(OR^7)_{4-n-l}$ (4)

(wherein $R^5$ represents an alkyl group having one or more epoxy group in a part of its chain and in the case of a plurality of $R^5$s, $R^5$s may be the same or different, $R^6$ represents hydrogen, an alkyl group, a heterocyclic group, an aryl group or an alkenyl group and in the case of a plurality of $R^6$s, $R^6$s may be the same or different, $R^7$ represents hydrogen, an alkyl group, an acyl group or an aryl group and in the case of a plurality of $R^7$s, $R^7$s may be the same or different, 1 is an integer of 0 to 2, and n represents 1 or 2, satisfying $1 + n \leq 3$).

**11.** The composition according to any one of claims 7 to 10, wherein the metal chelate is an aluminum chelate represented by the following general formula (2):

$R^1_3Al$ (2)

(wherein $R^1$s are the same as the $R^1$s in the general formula (1), and $R^1$s may be the same or different).

**12.** A method for manufacturing a field effect transistor having a gate insulating layer, a gate electrode, a semiconductor layer, a source electrode and a drain electrode, comprising a step of applying the composition according to any one of claims 7 to 11 onto a substrate and drying the composition to form the gate insulating layer.

[Figure 1]

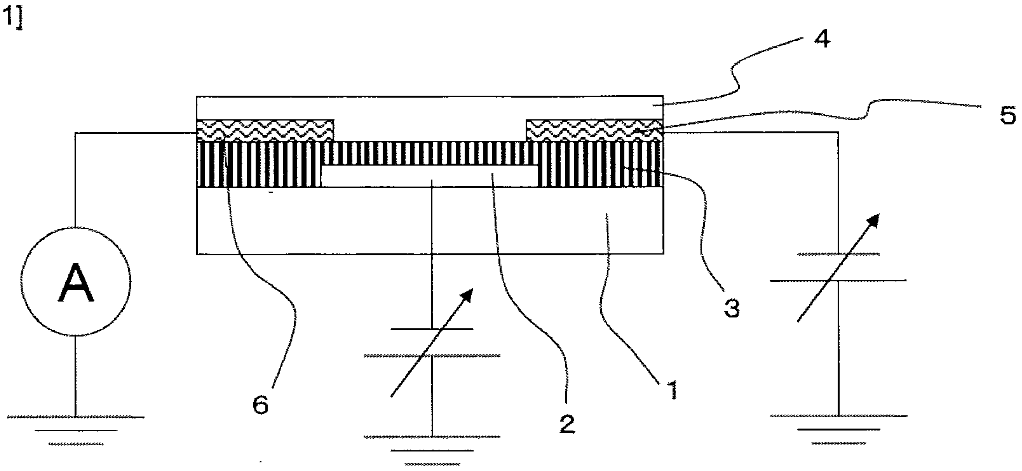


[Figure 2]

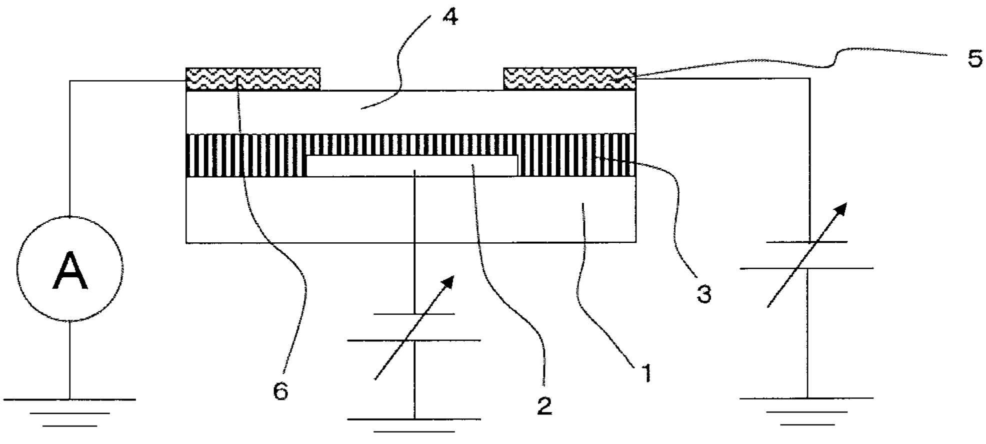

**INTERNATIONAL SEARCH REPORT**

International application No.
PCT/JP2014/056280

A. CLASSIFICATION OF SUBJECT MATTER
*H01L29/786*(2006.01)i, *C08G79/00*(2006.01)i, *H01L21/316*(2006.01)i, *H01L21/336*(2006.01)i, *H01L51/05*(2006.01)i, *H01L51/30*(2006.01)i, *H01L51/40*(2006.01)i

According to International Patent Classification (IPC) or to both national classification and IPC

B. FIELDS SEARCHED

Minimum documentation searched (classification system followed by classification symbols)
H01L29/786, C08G79/00, H01L21/316, H01L21/336, H01L51/05, H01L51/30, H01L51/40

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2013-1859 A (Toray Industries, Inc.), 07 January 2013 (07.01.2013), entire text; all drawings (Family: none) | 1-12 |
| A | JP 2012-119423 A (Toray Industries, Inc.), 21 June 2012 (21.06.2012), entire text; all drawings (Family: none) | 1-12 |
| A | JP 2006-83319 A (Toray Industries, Inc.), 30 March 2006 (30.03.2006), entire text; all drawings (Family: none) | 1-12 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 15 April, 2014 (15.04.14) | 28 April, 2014 (28.04.14) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No. PCT/JP2014/056280

C (Continuation). DOCUMENTS CONSIDERED TO BE RELEVANT

| Category* | Citation of document, with indication, where appropriate, of the relevant passages | Relevant to claim No. |
|---|---|---|
| A | JP 2006-73889 A (JSR Corp.), 16 March 2006 (16.03.2006), entire text; all drawings (Family: none) | 1-12 |
| A | JP 2007-154164 A (Samsung Electronics Co., Ltd.), 21 June 2007 (21.06.2007), entire text; all drawings & US 2007/0129473 A1 & KR 10-2007-0059283 A & CN 101012334 A | 1-12 |
| A | JP 2012-160698 A (Kaneka Corp.), 23 August 2012 (23.08.2012), entire text; all drawings (Family: none) | 1-12 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2009004394 A
- WO 2009116373 A
- JP 2002311591 A
- JP 2007154164 A
- JP 2012111864 A
- JP 2010267657 A


### Non-patent literature cited in the description


- *APPLIED PHYSICS LETTERS,* 2003, vol. 82, 4175-4177